# EUROPEAN PATENT APPLICATION

(11) **EP 4 826 975 A1**
(43) Date of publication of application: **21.10.2026**
(21) Application number: 24903368.9
(22) Date of filing: 30.10.2024
(51) Int. Cl.: H02M 1/08, H03K 5/00

(54) **DELAY CONTROL CIRCUIT**

(30) Priority: 13.12.2023 JP 2023210261
(71) Applicant: Tamura Corporation, Tokyo 178-8511 (JP); Tohoku University, Sendai-shi, Miyagi 980-8577 (JP)
(72) Inventor: AOKI, Hirotoshi, Sakado-shi, Saitama 350-0214 (JP); SHIBATA, Hisashi, Sakado-shi, Saitama 350-0214 (JP); MIYAJIMA, Hiromitsu, Sakado-shi, Saitama 350-0214 (JP); TAKAHASHI, Yoshikazu, Sendai-shi, Miyagi 980-8577 (JP); TAKAGI, Naoki, Sendai-shi, Miyagi 980-8577 (JP)
(74) Representative: Becker, Eberhard
(86) International application number: PCT/JP2024/038759
(87) International publication number: WO 2025/126706

(57) **Abstract**

The present invention correctly synchronizes and drives a plurality of external devices connected in parallel. A FPGA 30 is provided with a delay control circuit for delaying PWMs 1, 2, 3 on the basis of Syncs 1, 2, 3. The delay control circuit comprises: a phase difference detection circuit 40 (phase difference detection unit) for detecting a phase difference between the Syncs 1, 2, 3 (input signals), which are inputted from a gate driver/SiC 100; a phase difference time measurement circuit 50 (phase difference time measurement unit) for measuring a phase difference time of the phase difference detected by the phase difference detection circuit 40; a correction rate integration circuit 60 (integration unit) for calculating an integrated value by adding or subtracting the previous phase difference time to or from the current phase difference time measured by the phase difference time measurement circuit 50; a delay time determination circuit 70 (delay time determination unit) for determining a delay time of the PWMs 1, 2, 3 (output signals) on the basis of the integrated value calculated by the correction rate integration circuit 60; and a delay circuit 80 (delay unit) for delaying the PWMs 1, 2, 3 on the basis of the determined delay time.

## Description

### Technical Field

The present invention relates to a delay control circuit.

### Background Art

Patent Document 1 discloses a technique of connecting external devices to be driven in parallel and driving the external devices by gate drivers.

### Related Art Documents

### Patent Documents

Patent Document 1: Japanese Patent No. 6915890

### SUMMARY OF INVENTION

### Problem to Be Solved by Invention

In a technique of performing parallel driving such as that of Patent Document 1, a technique capable of correctly synchronizing and driving multiple external devices connected in parallel is desired.

Accordingly, the present invention provides a delay control circuit capable of correctly synchronizing and driving multiple external devices connected in parallel.

### Means for Solving Problem

The present invention adopts the following solutions to address the above problem. The following solutions and the wording in parentheses are merely illustrative, and the present invention is not limited thereto. The present invention may also be an invention including at least one of the invention-specifying items presented in the following solutions. Furthermore, each of the invention-specifying items presented in the following solutions may be subordinated by adding elements that limit the invention-specifying items, or may be generalized by removing elements that limit the invention-specifying items.

Solution 1: A delay control circuit of the present solution is configured to output an output signal to each of multiple external devices connected in parallel, receive an input signal based on the output signal from each of the external devices, and delay the output signal based on the input signal. The delay control circuit includes a phase difference detection unit, a phase difference time measurement unit, an integration unit, a delay time determination unit, and a delay unit. The phase difference detection unit is configured to detect a phase difference of the input signal inputted from each of the external devices. The phase difference time measurement unit is configured to measure a phase difference time of the phase difference detected by the phase difference detection unit. The integration unit is configured to calculate an integrated value by performing addition and subtraction of a previous phase difference time with respect to a current phase difference time measured by the phase difference time measurement unit. The delay time determination unit is configured to determine a delay time of the output signal based on the integrated value calculated by the integration unit. The delay unit is configured to delay the output signal based on the delay time determined by the delay time determination unit.

According to the present solution, because the output signal is delayed based on the input signal, variations in the phase of the external devices can be suppressed, and the multiple external devices can be correctly synchronized and driven.

Solution 2: In the delay control circuit of the present solution according to any of the above solutions, the integration unit multiplies the current phase difference time measured by the phase difference time measurement unit by a predetermined correction factor.

According to the present solution, because a correction factor is used, the multiple external devices can be gradually synchronized.

Solution 3: In the delay control circuit of the present solution according to any of the above solutions, a phase-locked loop is used as the phase difference time measurement unit.

According to the present solution, because a phase-locked loop is employed, time measurement and signal delay can be performed at a resolution beyond the maximum operating frequency of the delay control circuit.

### Effects of Invention

According to the present invention, multiple external devices connected in parallel can be correctly synchronized and driven.

### BRIEF DESCRIPTION OF DRAWINGS

[FIG. 1] is a diagram illustrating a drive circuit 10 of an embodiment.
[FIG. 2] is a diagram illustrating a relationship between Ids and PWM.
[FIG. 3] is a diagram illustrating a configuration of a power switching device.
[FIG. 4] is a diagram illustrating a configuration of a delay control circuit.
[FIG. 5] is a diagram illustrating timing of each signal of an FPGA.
[FIG. 6] is a diagram illustrating details of the delay control circuit.
[FIG. 7] is a diagram illustrating details of a phase difference detection circuit 40.
[FIG. 8] is a diagram illustrating details of a phase difference time measurement circuit 50.
[FIG. 9] is a diagram illustrating details of a correction factor integration circuit 60.
[FIG. 10] is a diagram illustrating a part of functions of the correction factor integration circuit 60.
[FIG. 11] is a diagram illustrating details of a delay time determination circuit 70.
[FIG. 12] is a diagram illustrating a concept of processing contents of the delay time determination circuit 70 (in the case of two Sync).
[FIG. 13] is a diagram illustrating a concept of processing contents of the delay time determination circuit 70 (in the case of three Sync).
[FIG. 14] is a diagram illustrating details of a delay circuit 80.
[FIG. 15] is a diagram illustrating the delay circuit 80 of FIG. 14 in a simplified manner.
[FIG. 16] is a sequence diagram illustrating a case where PWM is detected by CLK1 in the delay circuit 80.
[FIG. 17] is a sequence diagram illustrating a case where PWM is detected by CLK2 in the delay circuit 80.
[FIG. 18] is a diagram illustrating details of a PWM rise CLK selection circuit.
[FIG. 19] is a diagram illustrating signals related to the PWM rise CLK selection circuit.
[FIG. 20] is a diagram illustrating actual signals related to the PWM rise CLK selection circuit.
[FIG. 21] is a conceptual diagram illustrating processing contents of a part of the delay circuit 80.
[FIG. 22] is a diagram illustrating a circuit configuration of an FPGA for 3-parallel feedback control.
[FIG. 23] is a diagram illustrating a circuit configuration of an FPGA for 2-parallel feedback control.
[FIG. 24] is a diagram illustrating a circuit configuration of an FPGA for multi-parallel feedback control.
[FIG. 25] is a diagram illustrating a modification example of the phase difference time measurement circuit 50.
[FIG. 26] is a diagram illustrating a configuration of an operation evaluation circuit for 3-parallel feedback control.
[FIG. 27] is a diagram illustrating an overview of a processing of the correction factor.
[FIG. 28] is a diagram illustrating measurement results in the case of a correction factor of 1.0.
[FIG. 29] is a diagram illustrating measurement results in the case of a correction factor of *0.5.*
[FIG. 30] is a diagram illustrating measurement results of a jitter.
[FIG. 31] is a diagram illustrating a configuration of a correction limiter.
[FIG. 32] is a diagram illustrating measurement results of the correction limiter.
[FIG. 33] is a diagram illustrating details of measurement results of the correction limiter.

### DESCRIPTION OF EMBODIMENTS

Hereinafter, embodiments of the present invention will be described with reference to the drawings.

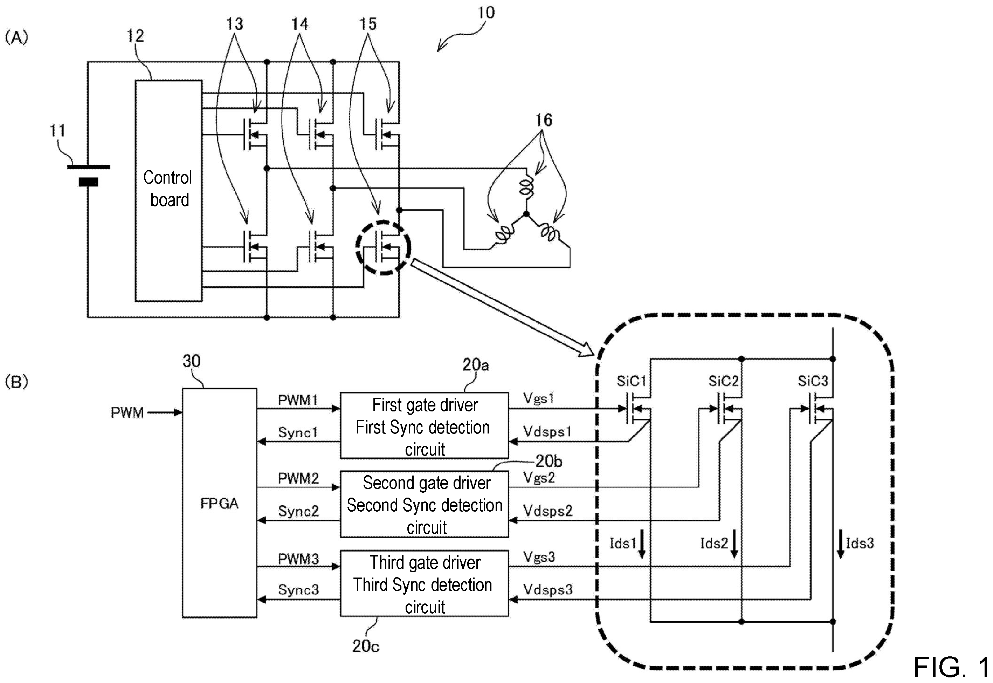

FIG. 1 is a diagram illustrating a drive circuit 10 of an embodiment. FIG. 1(A) illustrates an overview of the drive circuit 10, and FIG. 1(B) illustrates details of a dotted-line portion of FIG. 1(A) and circuits connected thereto.

As illustrated in FIG. 1(A), the drive circuit 10 includes a power supply 11, a control board 12, three-phase power switching devices 13, 14, and 15, and three coils 16.

The three-phase power switching devices 13, 14, and 15 are each configured by two power switching devices shown in an upper and lower arrangement.

In the drive circuit 10, the control board 12 operates by the power from the power supply 11, and the control board 12 performs gate control on the three-phase power switching devices 13, 14, and 15, thereby driving a motor (not illustrated) by the three coils 16. Herein, the drive circuit 10 drives a motor; however, the drive circuit 10 may also be a circuit configured to drive a device other than a motor.

The dotted-line portion of FIG. 1(A) may ordinarily be one power switching device; however, in cases where the current is insufficient, multiple power switching devices may be connected in parallel.

A delay control circuit of the present embodiment is a circuit used in the case where multiple power switching devices are connected in parallel in such a situation. Details of the delay control circuit will be described later.

As illustrated in FIG. 1(B), SiC1, SiC2, and SiC3 serving as power switching devices are connected in parallel. SiC refers to a power semiconductor using a silicon carbide semiconductor, which is a compound.

SiC1 is connected to a first gate driver 20a, and the first gate driver 20a is connected to a field programmable gate array (FPGA) 30. SiC2 is connected to a second gate driver 20b, and the second gate driver 20b is connected to the FPGA 30. SiC3 is connected to a third gate driver 20c, and the third gate driver 20c is connected to the FPGA 30.

PWM is inputted to the FPGA 30 from the control board 12 (upper side).

The FPGA 30 outputs PWM1 to the first gate driver 20a, and Sync1 is inputted from the first gate driver 20a. The FPGA 30 outputs PWM2 to the second gate driver 20b, and Sync2 is inputted from the second gate driver 20b. The FPGA 30 outputs PWM3 to the third gate driver 20c, and Sync3 is inputted from the third gate driver 20c. PWM (pulse width modulation) refers to a signal that controls electrical components and the like using rectangular wave pulses. Sync (synchronization) refers to a signal for aligning the operation timing among various devices (synchronization signal).

The first gate driver 20a outputs Vgs1 to SiC1, and Vdsps1 is inputted from SiC1. The second gate driver 20b outputs Vgs2 to SiC2, and Vdsps2 is inputted from SiC2. The third gate driver 20c outputs Vgs3 to SiC3, and Vdsps3 is inputted from SiC3. SiC1, SiC2, and SiC3 output Ids1, Ids2, and Ids3, respectively. Vgs is a gate-to-source voltage. Vdsps is a voltage between the driver source and the power source of a four-terminal power switching device SiC. Ids is a current flowing from the drain to the source.

Although not particularly illustrated, Ids1 outputted by SiC1 is also inputted to the first gate driver 20a, Ids2 outputted by SiC2 is also inputted to the second gate driver 20b, and Ids3 outputted by SiC3 is also inputted to the third gate driver 20c. Each gate driver includes a Sync detection circuit, and is capable of detecting Sync based on Vdsps (potential difference between the driver source and the power source) and Ids inputted to the Sync detection circuit, and outputting Sync1, Sync2, and Sync3 to the FPGA 30.

A circuit configured to transmit PWM to the FPGA 30, the first gate driver 20a, the second gate driver 20b, and the third gate driver 20c may be implemented as a part of the functions of the control board 12. On the other hand, the FPGA 30 may be implemented as a function separate from the control board 12. The delay control circuit of the present embodiment is incorporated into the FPGA 30.

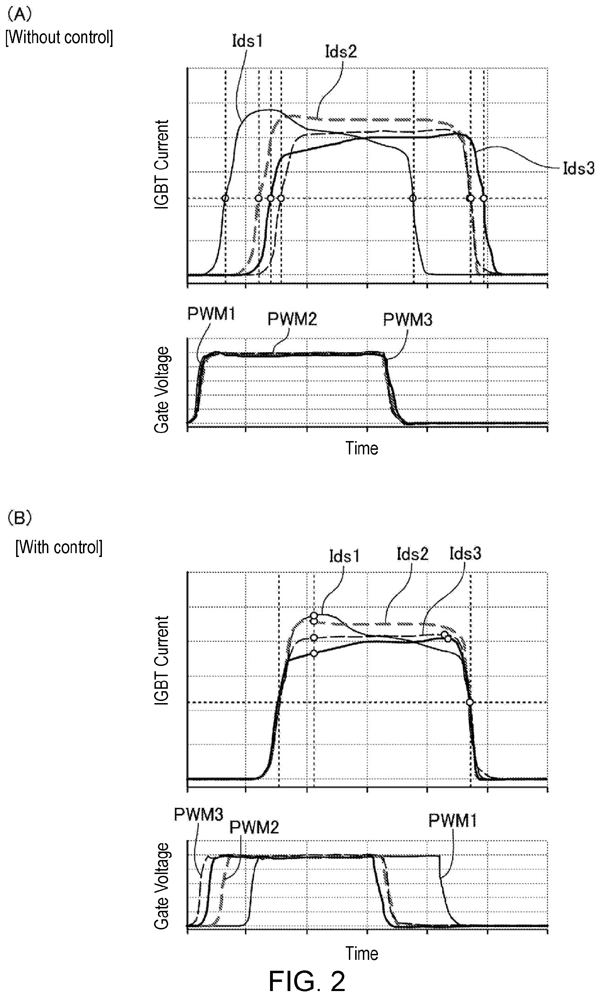

FIG. 2 is a diagram illustrating a relationship between Ids and PWM. FIG. 2(A) illustrates the case where control by the delay control circuit is absent, and FIG. 2(B) illustrates the case where control by the delay control circuit is present.

As illustrated in FIG. 2(A), in the case where control by the delay control circuit is absent, PWM is inputted from the control board 12 to the FPGA 30, and the FPGA 30 outputs PWM1, PWM2, and PWM3 to the power switching devices at the same timing via the respective gate drivers.

In such a case, PWM1, PWM2, and PWM3 are outputted at the same timing; however, Ids1, Ids2, and Ids3 (currents from the power switching devices) have waveforms in which the rise and fall timings are deviated from each other. Such a variation is attributed to individual differences among devices, temperature distributions of the devices, aging degradation of the devices, and the like.

In contrast, as illustrated in FIG. 2(B), in the case where control by the delay control circuit is present, PWM is inputted from the control board 12 to the FPGA 30, and the FPGA 30 outputs PWM1, PWM2, and PWM3 to the power switching devices at different timings via the respective gate drivers.

In such a case, PWM1, PWM2, and PWM3 are outputted at different timings; however, Ids1, Ids2, and Ids3 have waveforms in which the rise and fall timings are not deviated from each other. This is because the output timings of PWM1, PWM2, and PWM3 are delayed based on the variation illustrated in FIG. 2(A). In the control by the delay control circuit, control is performed to eliminate the variation as illustrated in FIG. 2(A) and balance the currents as illustrated in FIG. 2(B). That is, in the control by the delay control circuit, PWM1, PWM2, and PWM3 are forcibly delayed to align the waveforms of Ids1, Ids2, and Ids3, in order to eliminate the variation in currents.

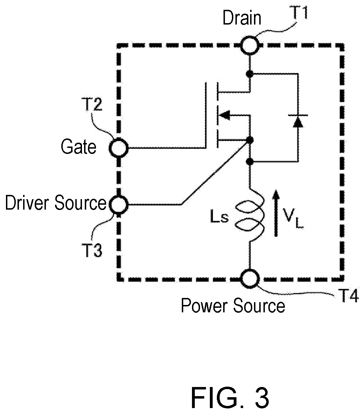

FIG. 3 is a diagram illustrating a configuration of a power switching device.

In the present embodiment, a four-terminal power switching device is employed. For example, SCT3040KR (manufactured by ROHM Co., Ltd.) may be used as the four-terminal power switching device. The four terminals are a drain T1, a gate T2, a driver source T3, and a power source T4, and in the present embodiment, control is performed based on a potential difference (Vdsps and the like) between the driver source T3 and the power source T4.

In general, Ls of a power switching device ranges from several nH to over ten nH, and in the case where dID/dt reaches several A/ns, an electromotive voltage V_{L} of 10 V or more may be generated. Vdsps is a signal identical to V_{L}, and by increasing the sensitivity of the "Sync detection circuit", it becomes possible to detect an initial operation of Id. In the present embodiment, each signal is controlled such that the timings of the Vdsps signals are aligned, in order to balance the current distribution when the power switching devices are connected in parallel.

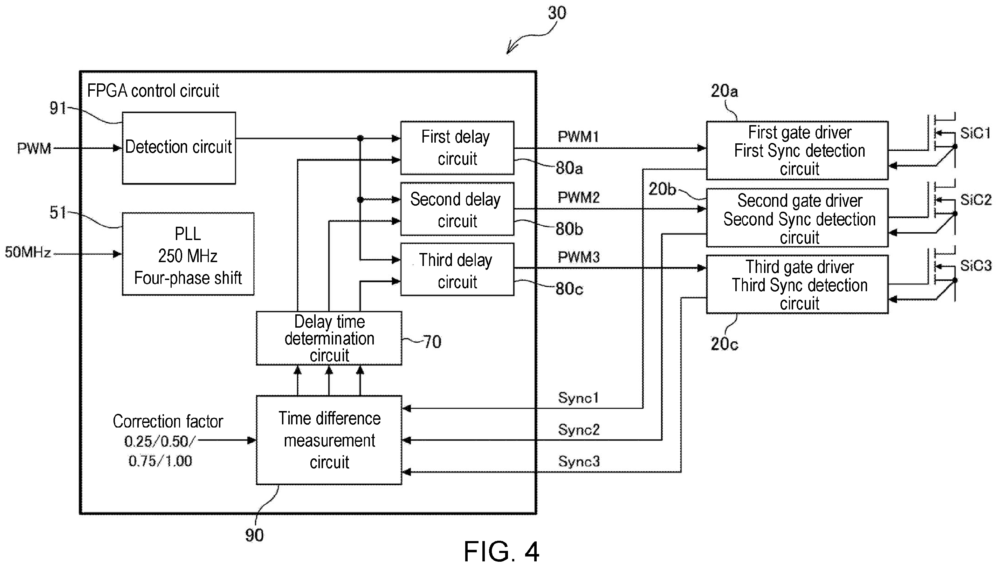

FIG. 4 is a diagram illustrating a configuration of a delay control circuit. The delay control circuit is a circuit for 3-parallel feedback control. SiC1, SiC2, and SiC3 are illustrated vertically for convenience, but are actually connected in parallel (see FIG. 1).

The FPGA 30 detects PWM via a detection circuit 91, generates PWM1, PWM2, and PWM3 via a first delay circuit 80a, a second delay circuit 80b, and a third delay circuit 80c, and outputs PWM1, PWM2, and PWM3 to the first gate driver 20a, the second gate driver 20b, and the third gate driver 20c.

In addition, Sync1, Sync2, and Sync3 are inputted to the FPGA 30 from the first gate driver 20a, the second gate driver 20b, and the third gate driver 20c, and feedback control is performed in a time difference measurement circuit 90, the delay time determination circuit 70, and the three delay circuits (the first delay circuit 80a, the second delay circuit 80b, and the third delay circuit 80c). In the time difference measurement circuit 90, a 250 MHz, four-phase shift PLL 51 is used. In addition, a correction factor (0.25, 0.50, 0.75, 1.00, etc.) may also be applied in the time difference measurement circuit 90. The correction factor is preferably a value of 1 or less.

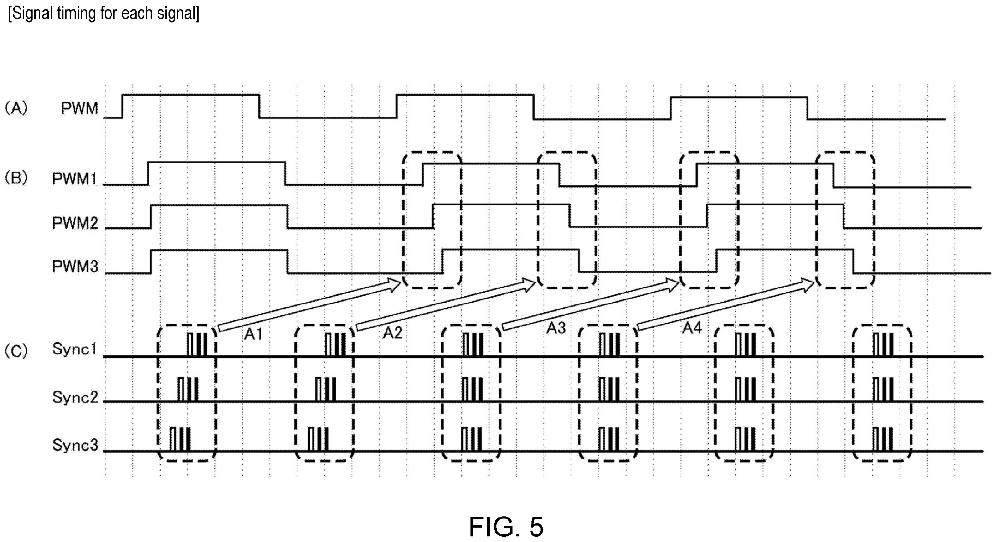

FIG. 5 is a diagram illustrating the timing of each signal of the FPGA.

As illustrated in FIG. 5(A), the PWM waveform is a signal outputted from the control board 12 to the FPGA 30. As illustrated in FIG. 5(B), the FPGA 30 outputs PWM1, PWM2, and PWM3 based on PWM. As illustrated in FIG. 5(C), in response to the FPGA 30 outputting PWM1, PWM2, and PWM3, Sync1, Sync2, and Sync3 are inputted to the FPGA 30.

Then, the FPGA 30 monitors the time differences of Sync1, Sync2, and Sync3. The time differences of Sync1, Sync2, and Sync3 are reflected in the subsequent PWM1, PWM2, and PWM3 (see an arrow A1). This applies to the turn-on side (rise side), and similarly, the time differences of Sync1, Sync2, and Sync3 are monitored for the turn-off side (fall side) and reflected in the subsequent PWM1, PWM2, and PWM3 (see an arrow A2).

Upon executing the processing of the arrow A1 and the arrow A2, Sync1, Sync2, and Sync3 are substantially aligned, but a slight deviation may be present in some cases. For this reason, the same processing is executed on the subsequent turn-on side as well. In such a case, the signal is delayed by the sum of the previous delay and the current delay (see an arrow A3). The same applies to the turn-off side (see an arrow A4). Thereafter, such processing is performed continuously.

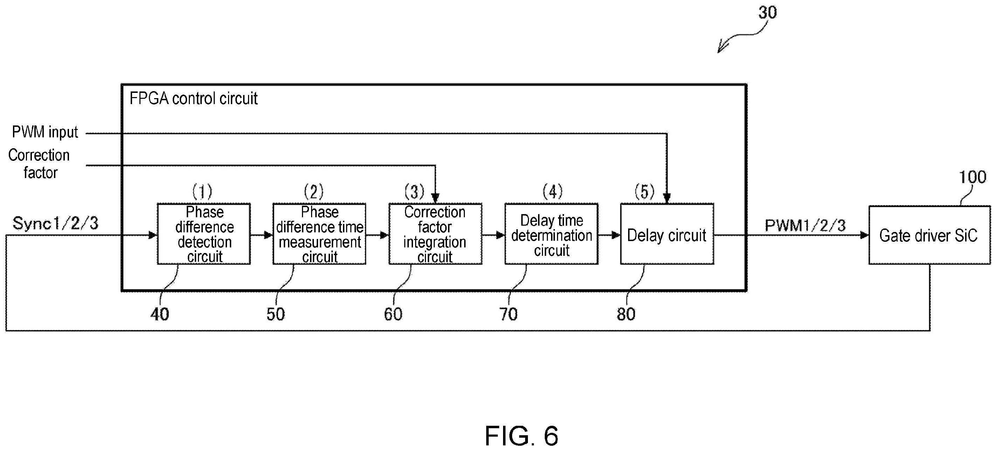

FIG. 6 is a diagram illustrating details of the delay control circuit.

The FPGA 30 includes a delay control circuit configured to output PWM1, PWM2, and PWM3 (output signals) to each gate driver SiC of multiple gate driver SiCs 100 (external devices) connected in parallel, receive Sync1, Sync2, and Sync3 (input signals) based on PWM1, PWM2, and PWM3 from each gate driver SiC, and delay PWM1, PWM2, and PWM3 based on Sync1, Sync2, and Sync3. Three gate driver SiCs 100 are connected in parallel, where the first corresponds to the first gate driver 20a and SiC1, the second corresponds to the second gate driver 20b and SiC2, and the third corresponds to the third gate driver 20c and SiC3 (see FIG. 1).

The delay control circuit of the FPGA 30 includes a phase difference detection circuit 40 (phase difference detection unit), a phase difference time measurement circuit 50 (phase difference time measurement unit), a correction factor integration circuit 60 (integration unit), a delay time determination circuit 70 (delay time determination unit), and a delay circuit 80 (delay unit).

### [(1) Phase difference detection circuit 40]

The phase difference detection circuit 40 is a circuit configured to detect phase differences of Sync1, Sync2, and Sync3 (input signals) inputted from each gate driver (each external device). Specifically, the phase difference detection circuit 40 detects the phase differences between Sync 1 and Sync2, Sync2 and Sync3, and Sync3 and Sync1.

### [(2) Phase difference time measurement circuit 50]

The phase difference time measurement circuit 50 is a circuit configured to measure a phase difference time of the phase difference detected by the phase difference detection circuit 40. In addition, the phase difference time measurement circuit 50 preferably employs a phase-locked loop (PLL). Specifically, the phase difference time measurement circuit 50 measures the phase difference with a resolution of 1 ns.

### [(3) Correction factor integration circuit 60]

The correction factor integration circuit 60 is a circuit configured to calculate an integrated value by performing addition and subtraction of a previous phase difference time with respect to a current phase difference time measured by the phase difference time measurement circuit 50. In addition, the correction factor integration circuit 60 preferably multiplies the current phase difference time measured by the phase difference time measurement circuit 50 by a predetermined correction factor. Specifically, the correction factor integration circuit 60 multiplies the current measured value by the correction factor and performs addition and subtraction with respect to the previous integrated value.

### [(4) Delay time determination circuit 70]

The delay time determination circuit 70 is a circuit configured to determine delay times of PWM1, PWM2, and PWM3 (output signals) based on the integrated values calculated by the correction factor integration circuit 60. Specifically, the delay time determination circuit 70 determines the delay times of PWM1, PWM2, and PWM3 from the integrated values.

### [(5) Delay circuit 80]

The delay circuit 80 is a circuit configured to delay PWM1, PWM2, and PWM3 based on the delay times determined by the delay time determination circuit 70. Specifically, the delay circuit 80 delays each delay time of PWM1, PWM2, and PWM3 with respect to the PWM input signal.

PWM1, PWM2, and PWM3 are outputted from the FPGA 30 to the gate driver SiCs 100 (PWM1 → first gate driver SiC1, PWM2 → second gate driver SiC2, PWM3 → third gate driver SiC3). On the other hand, Sync1, Sync2, and Sync3 are inputted from the gate driver SiCs 100 to the FPGA 30.

The phase difference detection circuit 40, the phase difference time measurement circuit 50, and the correction factor integration circuit 60 correspond to the time difference measurement circuit 90 (see FIG. 1).

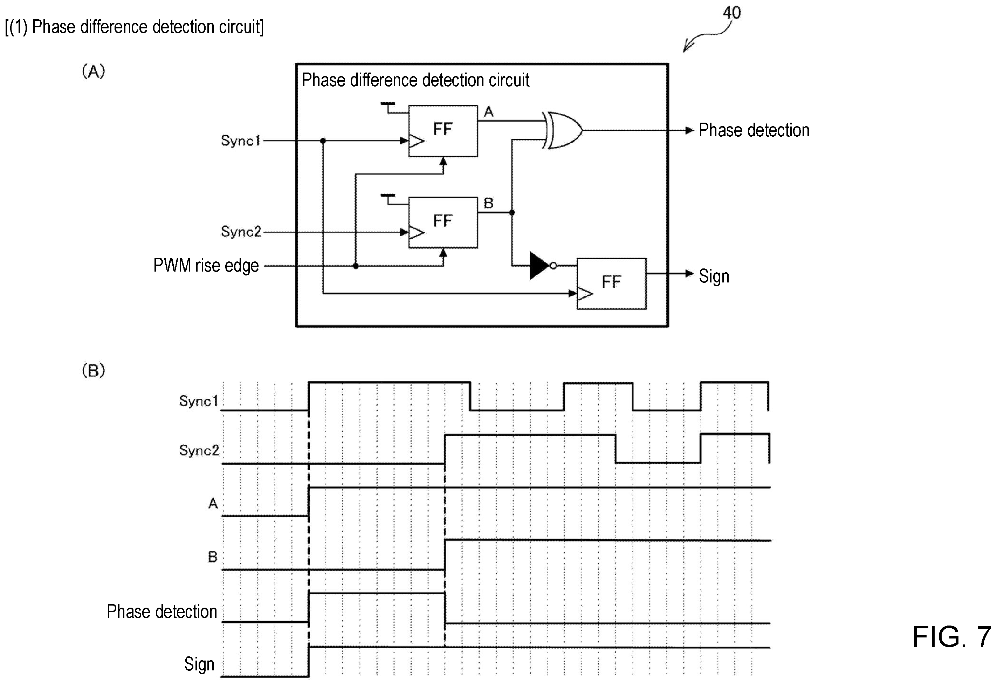

FIG. 7 is a diagram illustrating the details of the phase difference detection circuit 40. FIG. 7(A) illustrates the circuit configuration, and FIG. 7(B) illustrates a timing chart of each signal.

As illustrated in FIG. 7(A), the phase difference detection circuit 40 is a circuit configured to receive Sync1, Sync2, and a PWM rise edge as inputs, and output phase detection and a sign. Herein, Sync1 and Sync2 will be described as representative examples, but the same applies to Sync2 and Sync3, and Sync3 and Sync1.

In response to Sync1 and Sync2 being inputted to the FPGA 30, Sync1 and Sync2 are inputted to the clock portions of the upper-stage and middle-stage flip-flop circuits. In addition, the PWM rise edge is also inputted to the upper-stage and middle-stage flip-flop circuits. Then, data A is outputted from the upper-stage flip-flop circuit, and data B is outputted from the middle-stage flip-flop circuit. By inputting data A and data B to an exclusive OR circuit, phase detection is performed (phase difference detection).

In addition, Sync1 is inputted to the clock portion of the lower-stage flip-flop circuit. In addition, data B is inverted in value by an inverter circuit and inputted to the lower-stage flip-flop circuit. A sign is then outputted from the lower-stage flip-flop circuit.

As illustrated in FIG. 7(B), Sync1 and Sync2 with different waveforms are inputted. In such a case, taking the exclusive OR of data A and data B, it becomes High only in the portion where Sync1 is High (1) and Sync2 is Low (0), so this is used as the phase detection (phase difference between A and B). In addition, the sign is High in the illustrated case, which means that Sync1 rises first and Sync2 rises afterward. In the case where Sync2 rises first and Sync1 rises afterward, the sign remains Low.

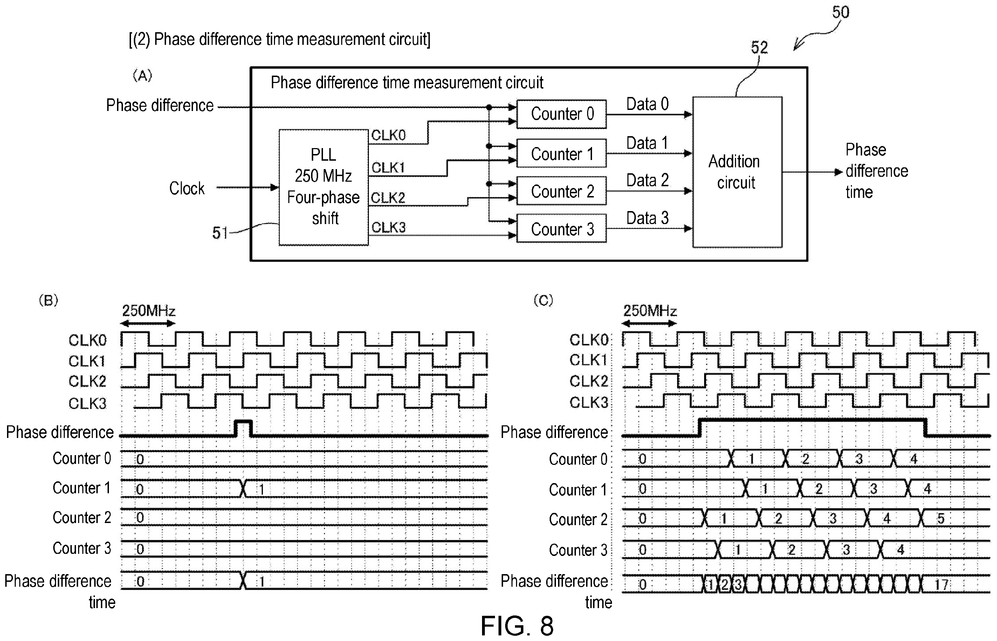

FIG. 8 is a diagram illustrating the details of the phase difference time measurement circuit 50. FIG. 8(A) illustrates the circuit configuration, FIG. 8(B) illustrates a timing chart of each signal in a first example, and FIG. 8(C) illustrates a timing chart of each signal in a second example.

As illustrated in FIG. 8(A), the phase difference time measurement circuit 50 is a circuit configured to receive a phase difference and a clock as inputs, and output a phase difference time. A phase difference (the pulse of the phase detection in FIG. 7) is inputted to the phase difference time measurement circuit 50, counters 0 to 3 are controlled by CLK0 to CLK3 generated by the PLL 51, and data 0 to data 3 are added by an addition circuit 52 to measure the phase difference time. In addition, the phase difference time measurement circuit 50 uses a 250 MHz, four-phase shift PLL 51 to measure (resolve) the phase difference pulse at a time resolution of 1 ns.

The PLL 51 uses a function (circuit) provided in the FPGA. The PLL 51 is used to raise the clock up to 250 ns and perform a four-phase shift. Accordingly, a continuous clock waveform at 250 MHz can be generated. CLK0 to CLK3 are waveforms each shifted by 90 degrees, with CLK1 shifted by 90 degrees with respect to CLK0, CLK2 shifted by 90 degrees with respect to CLK1, CLK3 shifted by 90 degrees with respect to CLK2, and CLK0 shifted by 90 degrees with respect to CLK3. Because 250 MHz corresponds to 4 ns, a shift of 90 degrees means that each clock has a shift of 1 ns.

Each grid square of the vertical lines illustrated in FIG. 8(B) and (C) corresponds to 1 ns.

As illustrated in FIG. 8(B), it is assumed that the waveform of the phase difference becomes High for a short period of time. In such a case, because the waveform of the phase difference becomes High only while CLK1 becomes High, counter 1 corresponding to CLK1 is set to 1. Thereafter, the waveform of the phase difference becomes Low, and this state continues. The values counted by each counter are added by the addition circuit 52 at the end. Accordingly, in the example of FIG. 8(B), the phase difference time is 1 (ns).

As illustrated in FIG. 8(C), it is assumed that the waveform of the phase difference becomes High over a longer period of time than in FIG. 8(B). In such a case, because the waveform of the phase difference becomes High in all of CLK0 to CLK3, counters 0 to 3 corresponding to CLK0 to CLK3 each perform counting. Specifically, counter 0 corresponding to CLK0 counts 4, counter 1 corresponding to CLK1 counts 4, counter 2 corresponding to CLK2 counts 5, and counter 3 corresponding to CLK3 counts 4. Thereafter, the waveform of the phase difference becomes Low, and this state continues. The values counted by each counter are added by the addition circuit 52 at the end. Accordingly, in the example of FIG. 8(C), the phase difference time is 4 + 4 + 5 + 4 = 17 ns. Each counter increments the count in response to the pulse of its own clock becoming High, if the inputted signal is High.

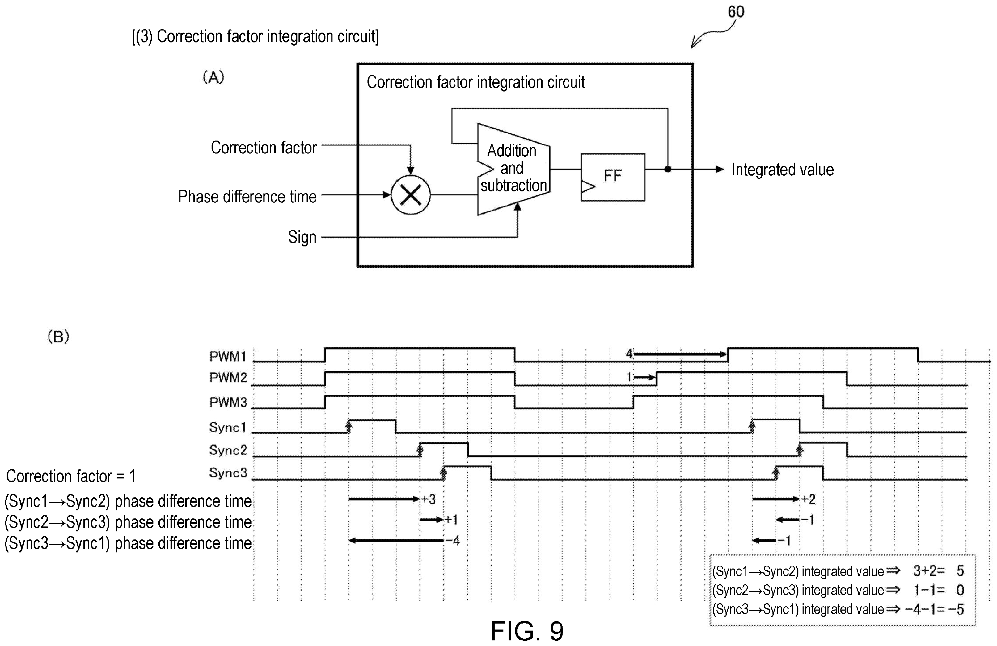

FIG. 9 is a diagram illustrating the details of the correction factor integration circuit 60. FIG. 9(A) illustrates the circuit configuration, and FIG. 9(B) illustrates a timing chart of each signal.

As illustrated in FIG. 9(A), the correction factor integration circuit 60 is a circuit configured to receive a correction factor, a phase difference time, and a sign as inputs, and output an integrated value. The correction factor serves to gradually delay the phase difference time, rather than delaying the phase difference time all at once. In the correction factor integration circuit 60, the correction factor and the current phase difference time are multiplied, the previous phase difference time is added to or subtracted from the current phase difference time, and a sign is added to output the integrated value.

For example, as illustrated in FIG. 9(B), PWM1, PWM2, and PWM3 are outputted. PWM1, PWM2, and PWM3 are in an initial state with no delay. Herein, "correction factor = 1" is described. In this regard, Sync1, Sync2, and Sync3 are inputted with a deviation as illustrated.

In such a case, the phase difference time is as follows.
(Sync1 → Sync2): phase difference time of Sync2 as viewed from Sync1: +3
(Sync2 → Sync3): phase difference time of Sync3 as viewed from Sync2: +1
(Sync3 → Sync1): phase difference time of Sync1 as viewed from Sync3: -4

In order to reflect the deviation of each Sync in the subsequent PWM1, PWM2, and PWM3, since it is difficult to advance a slow Sync, the approach is to delay a fast Sync instead. In the illustrated example, since Sync3 is the slowest, Sync1 and Sync2 are aligned to Sync3. Specifically, PWM1 corresponding to Sync1 is delayed by 4, and PWM2 corresponding to Sync2 is delayed by 1. PWM3 corresponding to Sync3 remains unchanged. Then, in response to the result of delaying each PWM signal, the subsequent Sync1, Sync2, and Sync3 are inputted.

In such a case, the phase difference time is as follows.
(Sync1 → Sync2): phase difference time of Sync2 as viewed from Sync1: +2
(Sync2 → Sync3): phase difference time of Sync3 as viewed from Sync2: -1
(Sync3 → Sync1): phase difference time of Sync1 as viewed from Sync3: -1

In such a case, the integrated value of (Sync1 → Sync2) is 5 (= 3 + 2), the integrated value of (Sync2 → Sync3) is 0 (= 1 - 1), and the integrated value of (Sync3 → Sync1) is -5 (= -4 - 1).

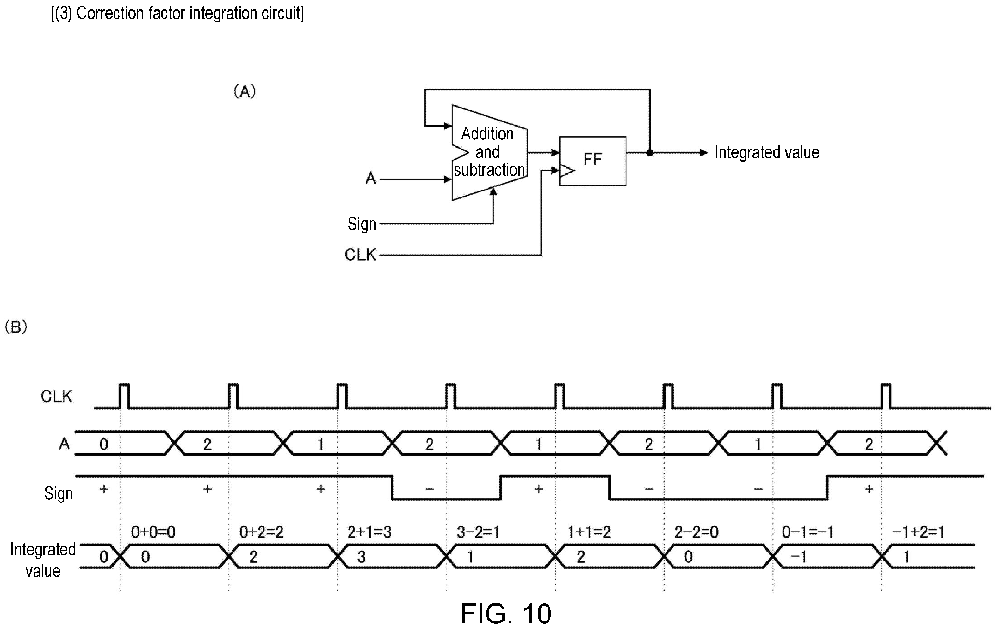

FIG. 10 is a diagram illustrating a part of the function of the correction factor integration circuit 60. FIG. 10(A) illustrates a part of the circuits of the correction factor integration circuit 60, and FIG. 10(B) illustrates a timing chart of each signal and values of various data.

As illustrated in FIG. 10(A), the circuit of addition and subtraction receives data A, a sign, and a value outputted from the flip-flop circuit (FF) as inputs, and outputs a value obtained by performing addition and subtraction on a value reflecting the sign in data A and the value outputted from the flip-flop circuit. In addition, the flip-flop circuit receives the value outputted from the circuit of addition and subtraction and CLK as inputs, outputs the value outputted from the circuit of addition and subtraction as an integrated value, and outputs the value outputted from the circuit of addition and subtraction to the circuit of addition and subtraction. Data A is data obtained by multiplying the correction factor of FIG. 9 and the current phase difference time.

As illustrated in FIG. 10(B), the initial value of data A is "0", the initial value of the sign is "+ (e.g., 0)", and the initial value of the integrated value is "0". In addition, regarding data A and the sign, different values are inputted as time elapses. In response to CLK being inputted to the flip-flop circuit, the circuit of addition and subtraction performs an operation, and the integrated value is outputted from the flip-flop circuit. Examples of the integrated value outputted are as follows.

At the first rise of CLK, data A is "0" and the sign is "+", so the integrated value is outputted as "0 (0 + 0 = 0)".

At the second rise of CLK, data A is "2" and the sign is "+", so the integrated value is outputted as "2 (0 + 2 = 2)".

At the third rise of CLK, data A is "1" and the sign is "+", so the integrated value is outputted as "3 (2 + 1 = 3)".

At the fourth rise of CLK, data A is "2" and the sign is "- (e.g., 1)", so the integrated value is outputted as "1 (3 - 2 = 1)".

At the fifth rise of CLK, data A is "1" and the sign is "+", so the integrated value is outputted as "2 (1 + 1 = 2)".

At the sixth rise of CLK, data A is "2" and the sign is "-", so the integrated value is outputted as "0 (2 - 2 = 0)".

At the seventh rise of CLK, data A is "1" and the sign is "-", so the integrated value is output as "-1 (0 - 1 = -1)".

At the eighth rise of CLK, data A is "2" and the sign is "+", so the integrated value is outputted as "1 (-1 + 2 = 1)".

In this manner, the correction factor integration circuit 60 retains the previous phase difference time using the flip-flop circuit.

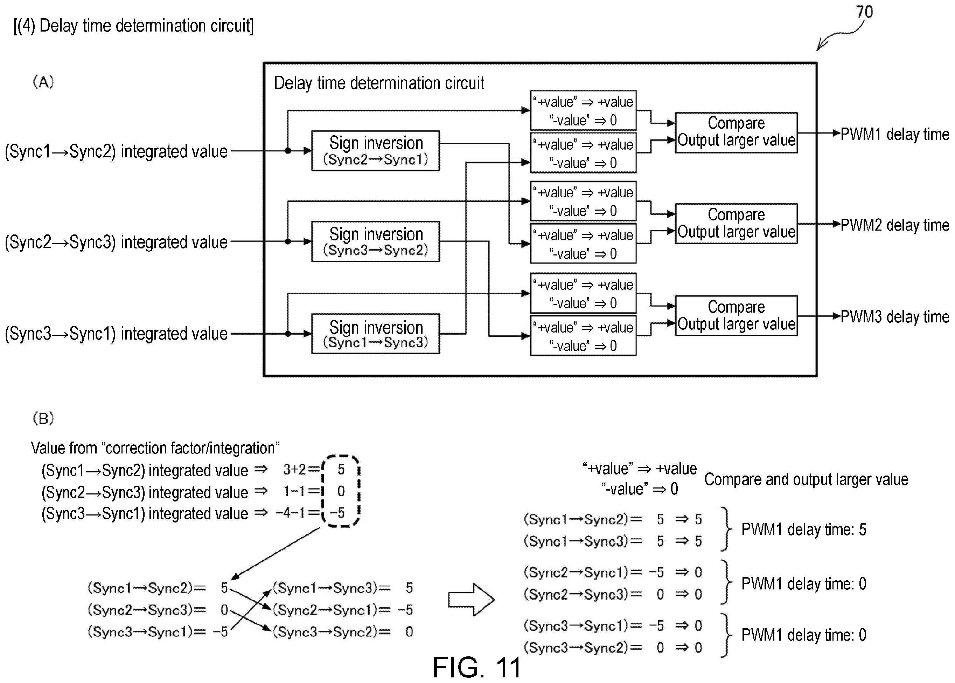

FIG. 11 is a diagram illustrating the details of the delay time determination circuit 70. FIG. 11(A) illustrates a circuit configuration, and FIG. 11(B) illustrates a specific calculation example.

As illustrated in FIG. 11(A), the delay time determination circuit 70 is a circuit configured to receive the integrated value of (Sync1 → Sync2), the integrated value of (Sync2 → Sync3), and the integrated value of (Sync3 → Sync1) as inputs, and output a PWM1 delay time, a PWM2 delay time, and a PWM3 delay time.

In the delay time determination circuit 70, the sign of the integrated value is first inverted, then a positive value is kept as a positive value and a negative value is converted to 0, and finally the values are compared and the larger value is outputted, which is used as the delay time of each PWM signal.

As illustrated in FIG. 11(B), for example, the integrated value of (Sync1 → Sync2) is 5, the integrated value of (Sync2 → Sync3) is 0, and the integrated value of (Sync3 → Sync1) is -5. Then, by inverting the positive and negative signs, the integrated value of (Sync1 → Sync3) becomes 5, the integrated value of (Sync2 → Sync1) becomes -5, and the integrated value of (Sync3 → Sync2) becomes 0.

Next, among the integrated values obtained so far, keeping the positive values as positive values and converting the negative values to 0, the following results are obtained.
(Sync1 → Sync2): Sync2 as viewed from Sync1: 5 → 5
(Sync1 → Sync3): Sync3 as viewed from Sync1: 5 → 5
(Sync2 → Sync1): Sync1 as viewed from Sync2: -5 → 0
(Sync2 → Sync3): Sync3 as viewed from Sync2: 0 → 0
(Sync3 → Sync1): Sync1 as viewed from Sync3: -5 → 0
(Sync3 → Sync2): Sync2 as viewed from Sync3: 0 → 0

Then, upon performing a final comparison and outputting the larger value, the delay time is as follows. The reason for setting negative values as 0 and selecting the larger value is to align the remaining Sync with the slowest Sync.
PWM1 delay time: 5
PWM2 delay time: 0
PWM3 delay time: 0

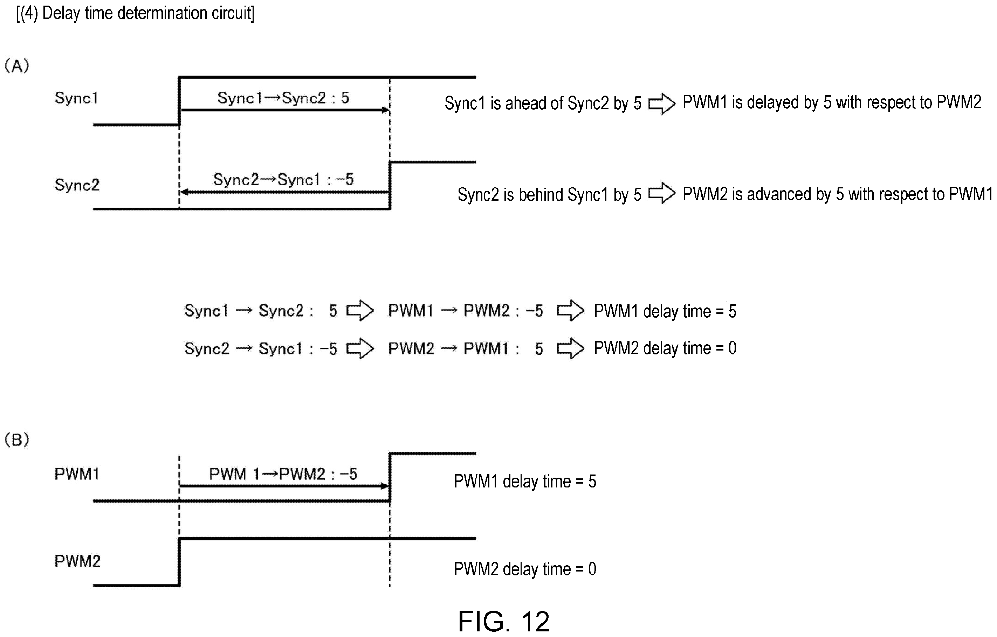

FIG. 12 is a diagram illustrating the concept of the processing content (in the case of two Sync) of the delay time determination circuit 70.

For example, it is assumed that Sync1 and Sync2 having waveforms as illustrated in FIG. 12(A) are inputted to the FPGA 30.
(1) Sync1 is ahead of Sync2 by 5 (Sync1 → Sync2: 5). In such a situation, to align Sync1 and Sync2, PWM1 needs to be delayed by 5 compared to PWM2.
(2) On the other hand, Sync2 is behind Sync1 by 5 (Sync2 → Sync1: -5). In such a situation, to align Sync1 and Sync2, PWM2 needs to be advanced by 5 compared to PWM1.
(3) Executing both (1) and (2) above merely swaps Sync1 and Sync2, so either (1) or (2) above needs to be executed. However, advancing PWM2 as in (2) above is difficult, so (2) is not executed, and instead the processing of delaying PWM1 as in (1) above is executed. Accordingly, the PWM1 delay time is set to 5, and the PWM2 delay time is set to 0.

Then, as illustrated in FIG. 12(B), PWM1 is delayed by 5, and PWM2 remains unchanged (PWM2 is not delayed). Setting the negative value to 0 in FIG. 11 means leaving PWM unchanged (not delaying it).

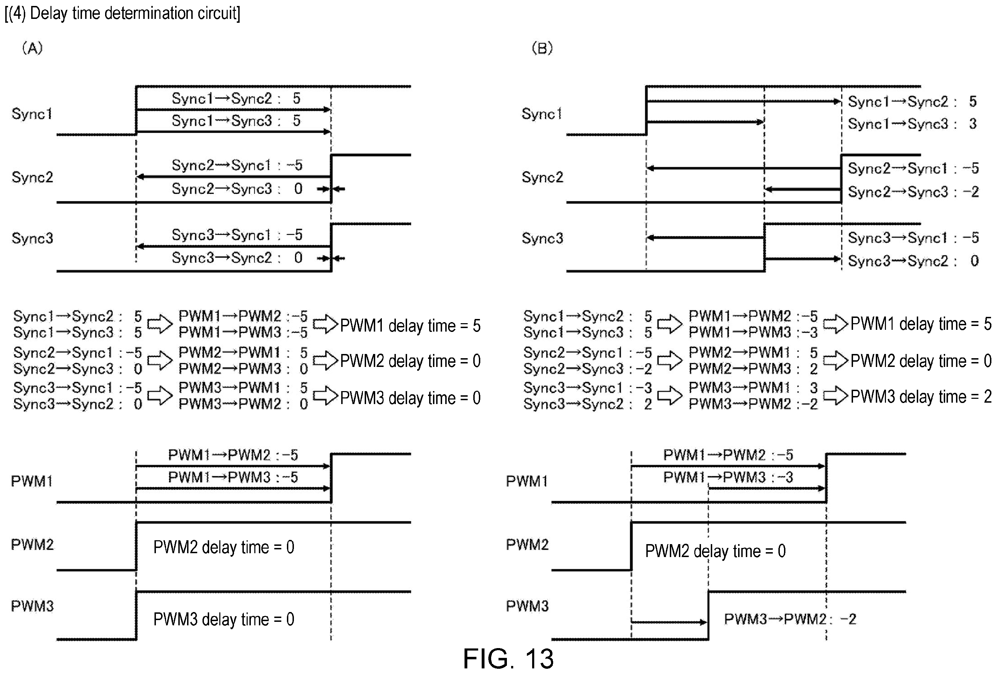

FIG. 13 is a diagram illustrating the concept of the processing content (in the case of three Sync) of the delay time determination circuit 70.

For example, it is assumed that Sync1, Sync2, and Sync3 having waveforms as illustrated in FIG. 13(A) are inputted to the FPGA 30. Herein, Sync2 and Sync3 are behind by a same amount of time with respect to Sync1.

The relationship between each Sync is as follows.
(Sync 1 → Sync2): Sync2 as viewed from Sync1: 5
(Sync1 → Sync3): Sync3 as viewed from Sync1: 5
(Sync2 → Sync1): Sync1 as viewed from Sync2: -5
(Sync2 → Sync3): Sync3 as viewed from Sync2: 0
(Sync3 → Sync1): Sync1 as viewed from Sync3: -5
(Sync3 → Sync2): Sync2 as viewed from Sync3: 0

The relationship of each PWM is as follows.
(PWM1 → PWM2): PWM2 as viewed from PWM1: -5
(PWM1 → PWM3): PWM3 as viewed from PWM1: -5
(PWM2 → PWM1): PWM1 as viewed from PWM2: 5
(PWM2 → PWM3): PWM3 as viewed from PWM2: 0
(PWM3 → PWM1): PWM1 as viewed from PWM3: 5
(PWM3 → PWM2): PWM2 as viewed from PWM3: 0

Based on such relationships, the PWM1 delay time = 5, the PWM2 delay time = 0, and the PWM3 delay time = 0.

Then, PWM1 is delayed by 5, and PWM2 and PWM3 remain unchanged (PWM2 and PWM3 are not delayed).

In addition, for example, it is assumed that Sync1, Sync2, and Sync3 having waveforms as shown in FIG. 13(B) are inputted to the FPGA 30. Herein, Sync2 and Sync3 are behind by different times with respect to Sync1.

The relationship of each Sync is as follows.
(Sync 1 → Sync2): Sync2 as viewed from Sync1: 5
(Sync1 → Sync3): Sync3 as viewed from Sync1: 5
(Sync2 → Sync1): Sync1 as viewed from Sync2: -5
(Sync2 → Sync3): Sync3 as viewed from Sync2: -2
(Sync3 → Sync1): Sync1 as viewed from Sync3: -3
(Sync3 → Sync2): Sync2 as viewed from Sync3: -2

The relationship of each PWM is as follows.
(PWM1 → PWM2): PWM2 as viewed from PWM1: -5
(PWM1 → PWM3): PWM3 as viewed from PWM1: -3
(PWM2 → PWM1): PWM1 as viewed from PWM2: 5
(PWM2 → PWM3): PWM3 as viewed from PWM2: 2
(PWM3 → PWM1): PWM1 as viewed from PWM3: 3
(PWM3 → PWM2): PWM2 as viewed from PWM3: -2

Based on such relationships, the PWM1 delay time = 5, the PWM2 delay time = 0, and the PWM3 delay time = 2.

Then, PWM1 is delayed by 5, PWM2 is left unchanged (PWM2 is not delayed), and PWM3 is delayed by 2.

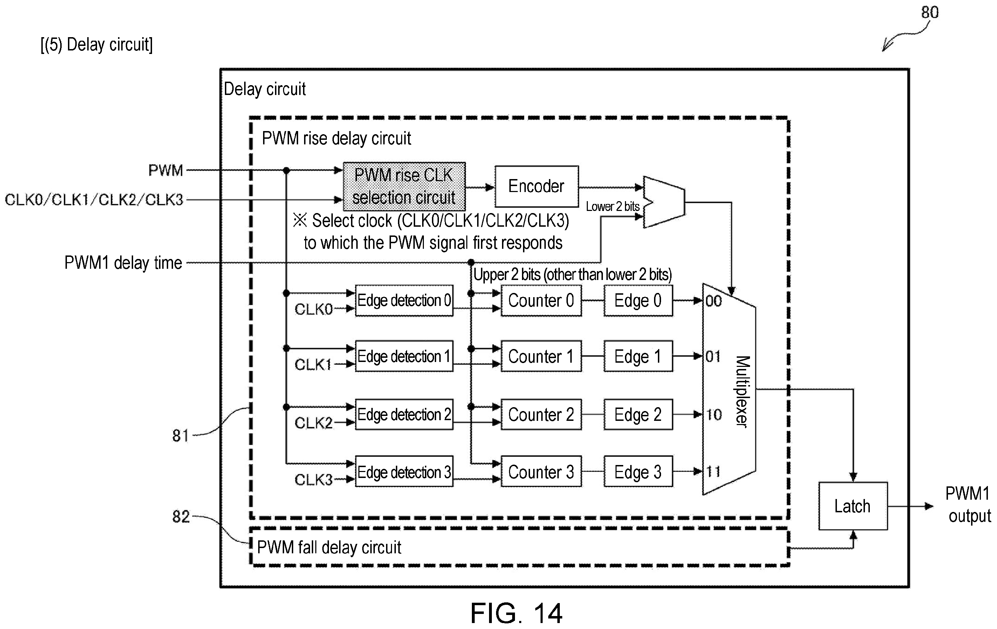

FIG. 14 is a diagram illustrating the details of the delay circuit 80.

The delay circuit 80 is a circuit configured to receive PWM, CLK0 to CLK3, and a PWM1 delay time as inputs, and output PWM1. In addition, the delay circuit 80 includes a PWM rise delay circuit 81 and a PWM fall delay circuit 82, and the output results of both circuits are latched (combined) and outputted. The difference between the PWM rise delay circuit 81 and the PWM fall delay circuit 82 only lies in that the PWM rise CLK selection is changed to a PWM fall CLK selection; therefore, a detailed description of the PWM fall delay circuit 82 will be omitted. In addition, the illustrated circuit is the delay circuit 80 for PWM1; however, a delay circuit 80 for PWM2 and a delay circuit 80 for PWM3 are also present. For the delay circuit 80 for PWM2 and the delay circuit 80 for PWM3, the PWM1 portion of the illustrated circuit is simply changed to PWM2 or PWM3, respectively; therefore, a detailed description will be omitted.

In the upper circuit within the PWM rise delay circuit 81, PWM and CLK0 to CLK3 are inputted to the PWM rise CLK selection circuit, and the rise of PWM is detected. The PWM rise CLK selection circuit selects the clock (CLK0, CLK1, CLK2, or CLK3) to which the PWM signal first responds. The detection result is then encoded and added to the lower 2 bits of the delay time to form an address of a multiplexer.

In the lower circuit within the PWM rise delay circuit 81, the edge of PWM is detected by edge detections 0 to 3, counters 0 to 3 are driven by the upper 2 bits of the PWM1 delay time, the edges of the carry signals are detected by edges 0 to 3, and pulses are outputted to the multiplexer. The upper circuit determines which of the pulses outputted to the multiplexer is selected. The pulse for rise outputted from the multiplexer is latched with a pulse for fall outputted from the multiplexer of the fall delay circuit, and PWM1 with the delay time reflected is ultimately outputted.

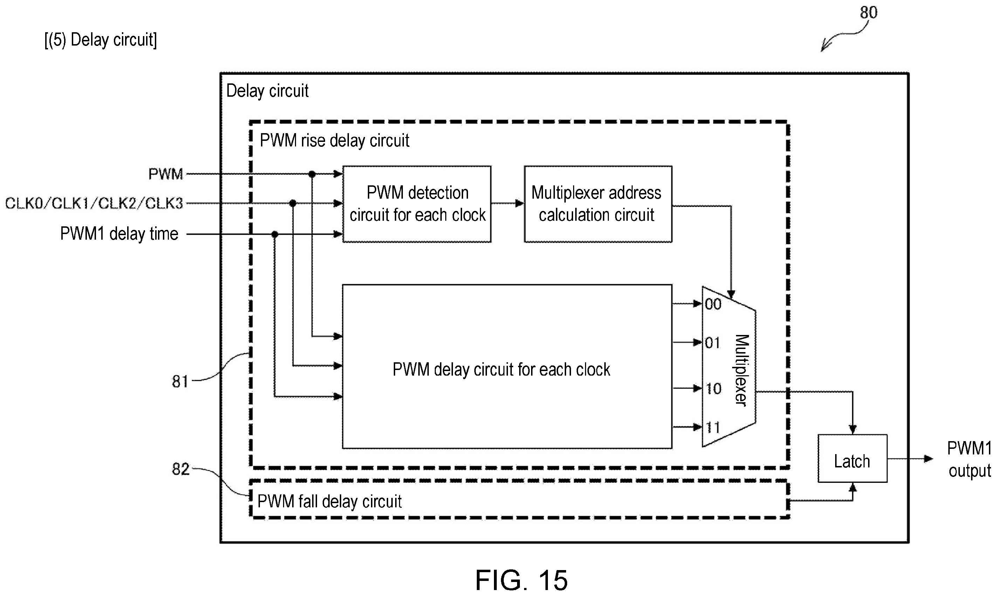

FIG. 15 is a diagram illustrating a simplified view of the delay circuit 80 of FIG. 14.

In the PWM detection circuit for each clock, the PWM signal is detected by each clock; in the multiplexer address calculation circuit, the address of the multiplexer is calculated; and in the PWM delay circuit for each clock, a pulse is outputted to the multiplexer based on each clock.

The delay circuit 80 latches the pulse for rise outputted from the multiplexer and the pulse for fall outputted from the multiplexer of the PWM fall delay circuit, and outputs PWM1 with the delay time reflected.

The upper circuit within the PWM rise delay circuit 81 of FIG. 14 corresponds to the PWM detection circuit for each clock and the multiplexer address calculation circuit of FIG. 15, and the lower circuit within the PWM rise delay circuit 81 of FIG. 14 corresponds to the PWM delay circuit for each clock and the multiplexer of FIG. 15.

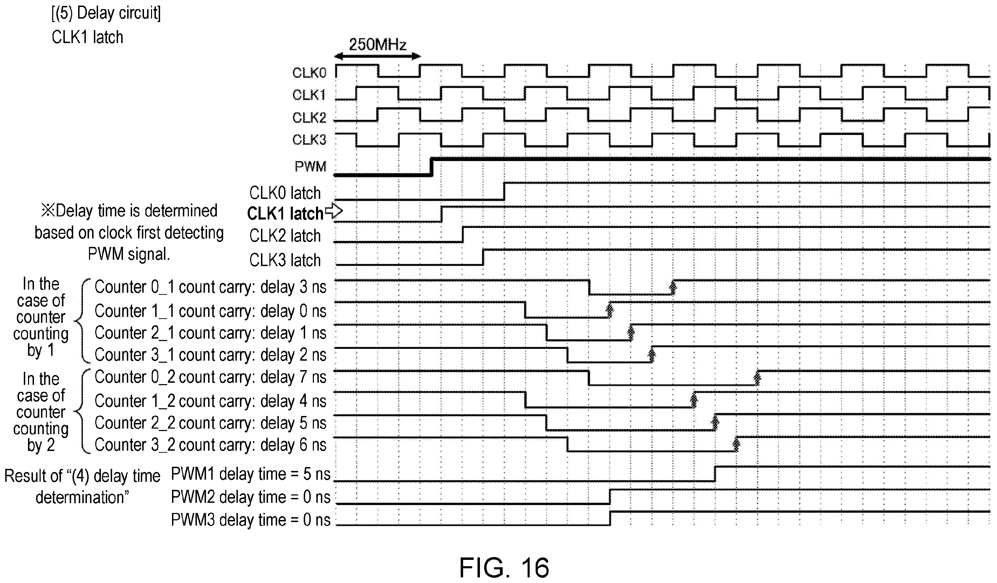

FIG. 16 is a sequence diagram illustrating the case where PWM is detected by CLK1 in the delay circuit 80.

In the illustrated example, CLK1 rises first after the PWM rises. The delay time is determined based on the clock (CLK1 in this example) that first detects the PWM signal.

The case where the counter counts by 1 (the output value in the case of setting the counter to 1) is as follows.
Counter 0_1 count carry: delay 3 ns
Counter 1_1 count carry: delay 0 ns
Counter 2_1 count carry: delay 1 ns
Counter 3_1 count carry: delay 2 ns

The case where the counter counts by 2 (the output value in the case of setting the counter to 2) is as follows. In the case of a desired delay of 8 ns or more, counter 3 or higher is used.
Counter 0_2 count carry: delay 7 ns
Counter 1_2 count carry: delay 4 ns
Counter 2_2 count carry: delay 5 ns
Counter 3_2 count carry: delay 6 ns

In the case where the delay time determination results are PWM1 delay time = 5 ns, PWM2 delay time = 0 ns, and PWM3 delay time = 0 ns, for PWM1 delay time = 5 ns, PWM1 is delayed up to the point corresponding to "counter 2_2 count carry: delay 5 ns" and outputted. For PWM2 delay time = 0 ns and PWM3 delay time = 0 ns, PWM2 and PWM3 are outputted at the point corresponding to "counter 1_1 count carry: delay 0 ns".

The timing of "counter 1_1 count carry: delay 0 ns" serving as reference may depend on the processing time of the circuit, but may be set to a timing delayed by 4 ns × N (N is an integer of 1 or more) from the timing at which CLK1 detects PWM.

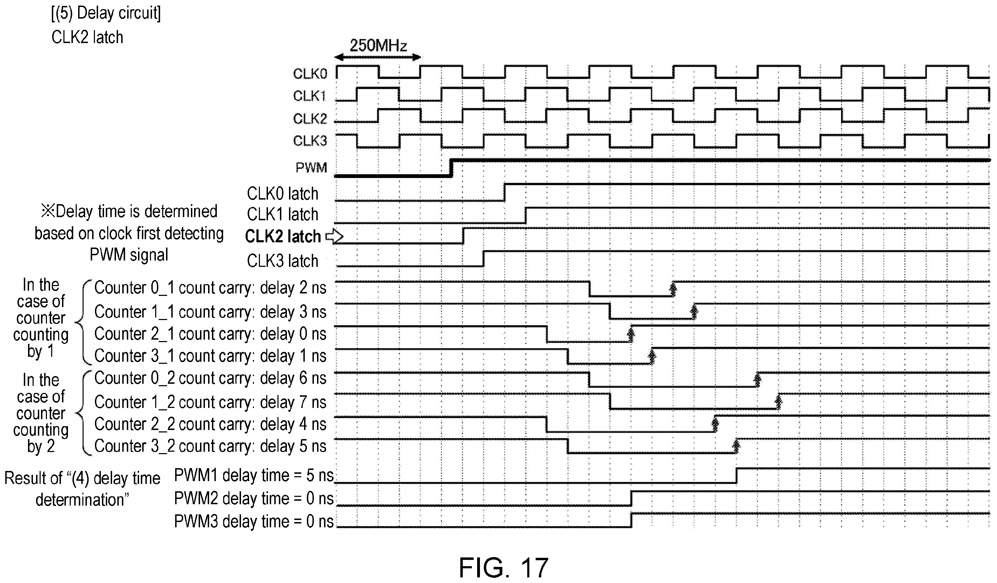

FIG. 17 is a sequence diagram of the delay circuit 80 in the case where PWM is detected by CLK2.

In the illustrated example, CLK2 rises first after PWM rises. The delay time is determined based on the clock (CLK2 in this example) that first detects the PWM signal.

The case where the counter counts by 1 is as follows.
Counter 0_1 count carry: delay 2 ns
Counter 1_1 count carry: delay 3 ns
Counter 2_1 count carry: delay 0 ns
Counter 3_1 count carry: delay 1 ns

The case where the counter counts by 2 is as follows.
Counter 0_2 count carry: delay 6 ns
Counter 1_2 count carry: delay 7 ns
Counter 2_2 count carry: delay 4 ns
Counter 3_2 count carry: delay 5 ns

In the case where the delay time determination results are PWM1 delay time = 5 ns, PWM2 delay time = 0 ns, and PWM3 delay time = 0 ns, for PWM1 delay time = 5 ns, PWM1 is delayed up to the point corresponding to "counter 3_2 count carry: delay 5 ns" and outputted. For PWM2 delay time = 0 ns and PWM3 delay time = 0 ns, PWM2 and PWM3 are outputted at the point corresponding to "counter 2_1 count carry: delay 0 ns".

The timing of "counter 2_1 count carry: delay 0 ns" serving as reference may depend on the processing time of the circuit, but may be a timing delayed by 4 ns × N (N is an integer of 1 or more) from the timing at which CLK2 detects PWM.

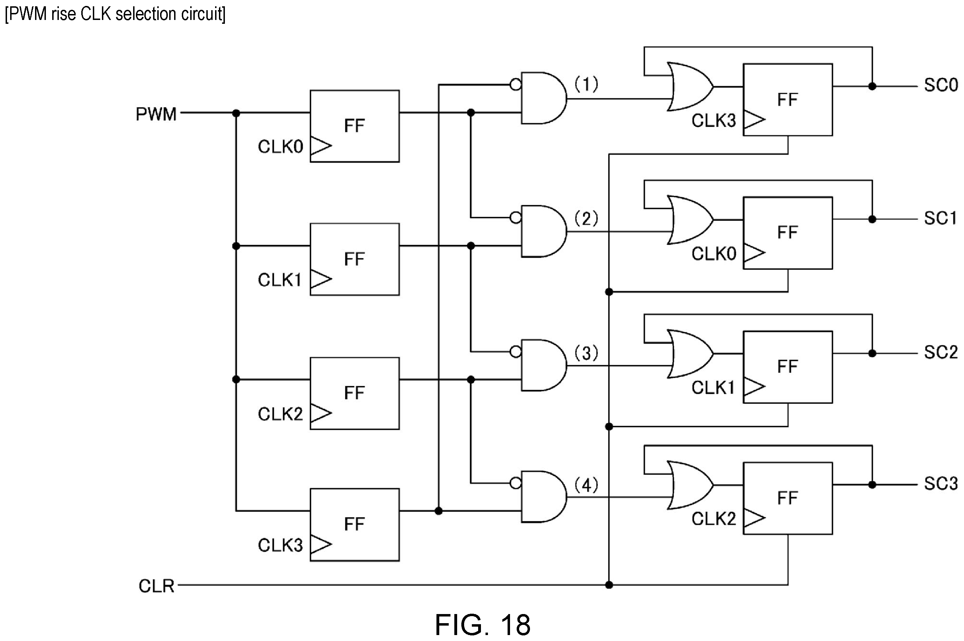

FIG. 18 is a diagram illustrating the details of the PWM rise CLK selection circuit. In the PWM fall CLK selection circuit, the rise processing is merely changed to fall processing, so description thereof will be omitted.

The PWM rise CLK selection circuit is a circuit configured to receive PWM and CLR (clear signal) as inputs, and output SC0 to SC3. The PWM rise CLK selection circuit includes flip-flop circuits, AND circuits, OR circuits, and the like, applies a latch at each CLK, executes processing based on a predetermined logic (for example, AND of the inversion of CLK0 and CLK3) after applying the latch, and outputs, via SC0 to SC3, which CLK has latched the rise of the PWM, based on PWM and CLK0 to CLK3.

CLK0 corresponds to SC0, CLK1 corresponds to SC1, CLK2 corresponds to SC2, and CLK3 corresponds to SC3. For example, in the case where PWM is latched by CLK1, SC1 corresponding to CLK1 becomes High.

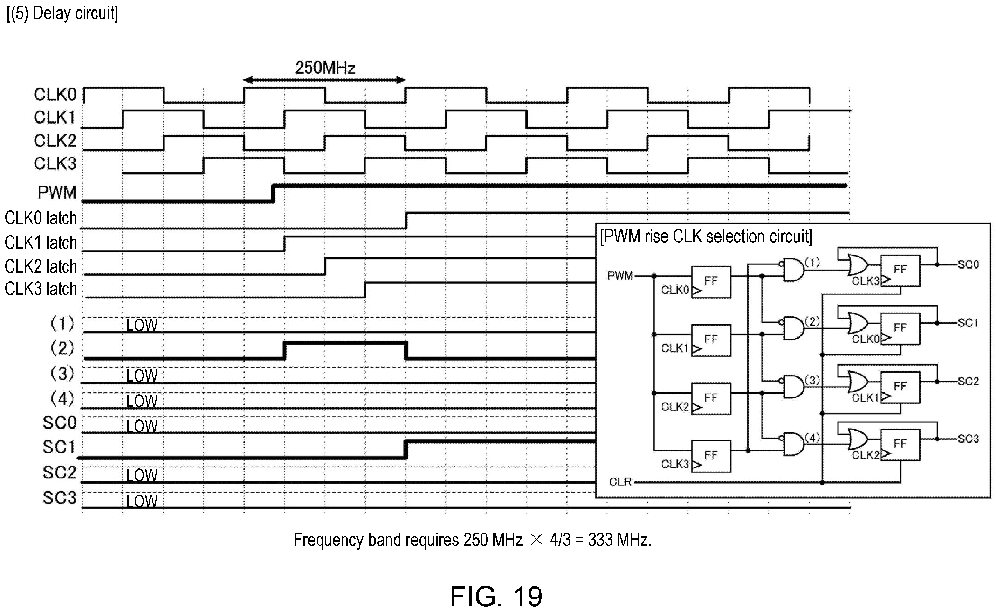

FIG. 19 is a diagram illustrating each signal related to the PWM rise CLK selection circuit.

In the upper portion of the diagram, CLK0 to CLK3 are illustrated, and each vertical dotted line corresponds to 1 ns.

In response to PWM being inputted to the FPGA 30, a latch is applied at CLK0 to CLK3. As a result, the output values of (1) to (4) and SC0 to SC3 take the values shown in the diagram.

For example, among the waveforms of (1) to (4) of the PWM rise CLK selection circuit, only (2) rises to High momentarily. This is because (2) becomes High when the CLK1 latch is High and the CLK0 latch is Low. On the other hand, in the case of CLK1 and CLK2, there is no period in which the CLK2 latch is High and the CLK1 latch is Low, so it is Low at all times. The same applies to the other CLK as well.

Then, it is desirable to hold the risen state of (2), and the timing for holding is at the fall of (2), at which SC1 is set to High. "SC1 = High (1)" means that CLK1 corresponding to SC1 has detected PWM first. The circuit actually operates at 250 MHz; however, to operate the circuit normally, it is preferable to ensure a frequency band of at least 333 MHz (= 250 MHz × 4/3) in consideration of a certain degree of margin and the like.

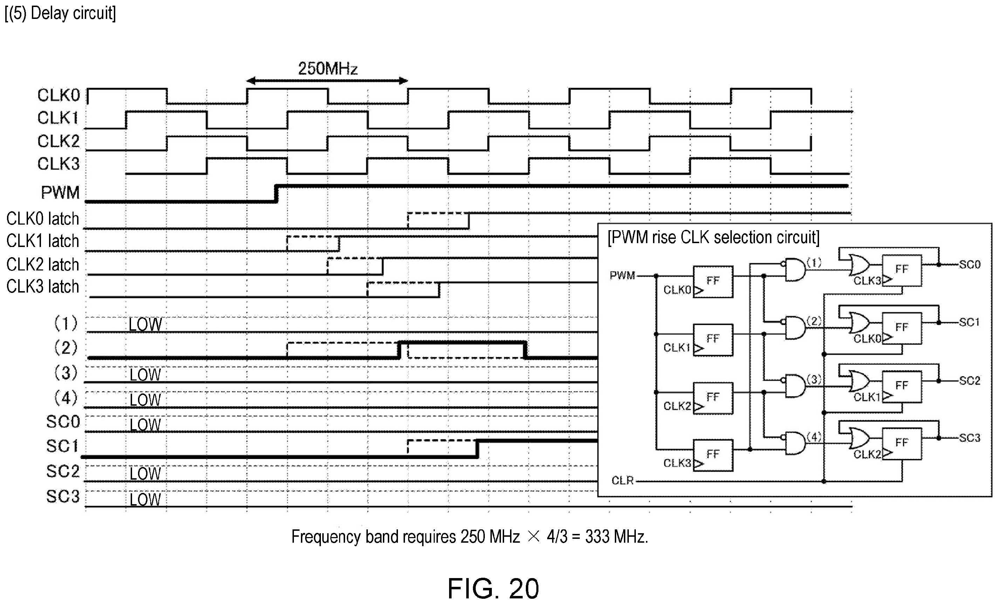

FIG. 20 is a diagram illustrating actual signals related to the PWM rise CLK selection circuit.

Each signal shown in FIG. 19 represents an ideal graph. In flip-flop circuits and other circuits, data is outputted at the same timing with respect to the clock; however, in practice, a delay occurs. For this reason, the actual waveforms take the form shown by the solid lines in FIG. 20. Even with such waveforms, the PWM rise CLK selection circuit of FIG. 18 is capable of outputting data as "SC1 = High (1)" without any issue. Because the FPGA of the present embodiment operates at 500 MHz, the delay is considered to be 2 ns or less; however, even with a delay of that magnitude, SC1 alone can be correctly set to High.

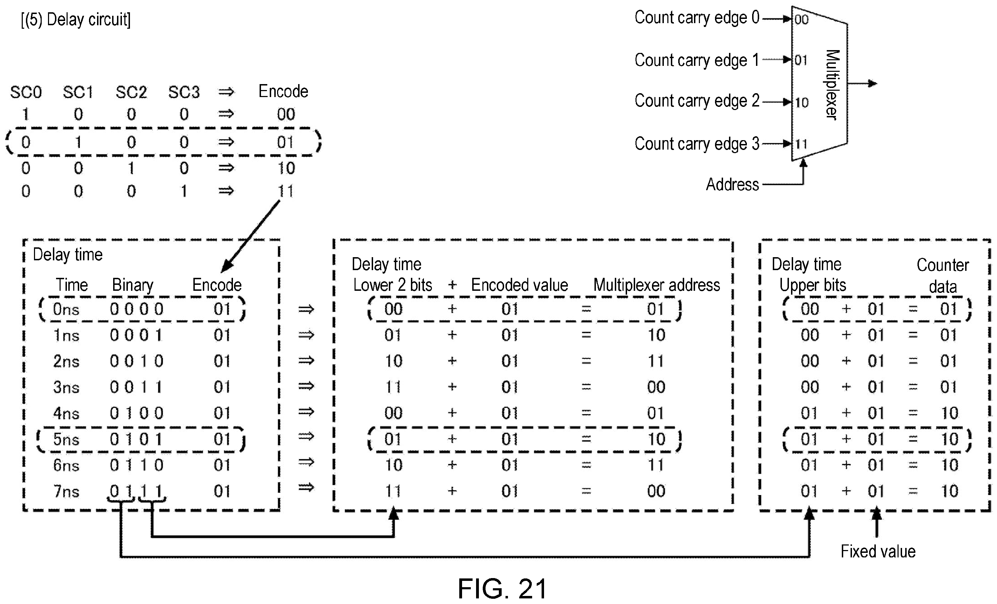

FIG. 21 is a conceptual diagram illustrating a part of the processing content of the delay circuit 80.

The delay circuit 80 encodes SC0 to SC3. The content of the encoded values is as follows.
SC0 = 1, SC1 = 0, SC2 = 0, SC3 = 0 → encoded value 00
SC0 = 0, SC1 = 1, SC2 = 0, SC3 = 0 → encoded value 01
SC0 = 0, SC1 = 0, SC2 = 1, SC3 = 0 → encoded value 10
SC0 = 0, SC1 = 0, SC2 = 0, SC3 = 1 → encoded value 11

The delay circuit 80 converts the delay time into a binary value. Specifically, the conversion is as follows.
Delay time 0 ns → 0000
Delay time 1 ns → 0001
Delay time 2 ns → 0010
Delay time 3 ns → 0011
Delay time 4 ns → 0100
Delay time 5 ns → 0101
Delay time 6 ns → 0110
Delay time 7 ns → 0111

The delay circuit 80 adds the lower 2 bits of the binary delay time and the encoded value to obtain the address of the multiplexer.

In addition, the delay circuit 80 adds the upper 2 bits (bits other than the lower 2 bits) of the binary delay time and a fixed value "01" to obtain counter data. The fixed value is a predetermined value, and is set to "01" in order to advance the counter at least once.

For example, in the case of a delay time of 0 ns, the address of the multiplexer is 01 and the counter is 01, which corresponds to the location of counter 1-1 (see FIG. 16). In addition, for example, in the case of a delay time of 5 ns, the address of the multiplexer is 10 and the counter is 10, which corresponds to the location of counter 2-2 (see FIG. 16).

The reason for dividing into upper bits and lower bits lies in that the clock operates at 250 MHz with a 4 ns cycle, and 4 ns corresponds to 2 squared, so taking 4 ns as a reference, a decimal point is placed at the second digit. The address to be selected is then determined by the fractional part, and the counter data is determined by the integer part.

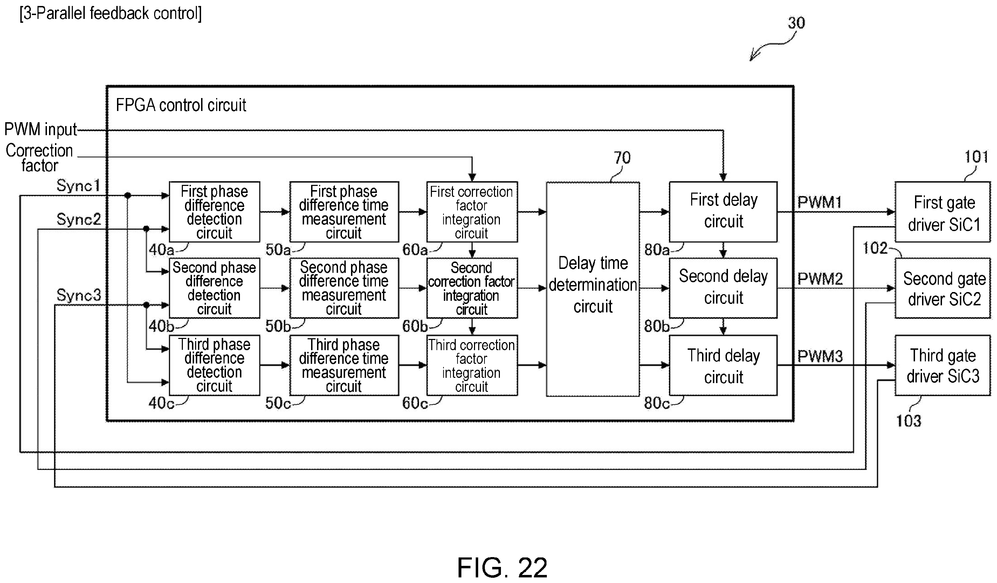

FIG. 22 is a diagram illustrating a circuit configuration of an FPGA for 3-parallel feedback control.

The phase difference detection circuits include a first phase difference detection circuit 40a, a second phase difference detection circuit 40b, and a third phase difference detection circuit 40c.

The phase difference time measurement circuits include a first phase difference time measurement circuit 50a, a second phase difference time measurement circuit 50b, and a third phase difference time measurement circuit 50c.

The correction factor integration circuits include a first correction factor integration circuit 60a, a second correction factor integration circuit 60b, and a correction factor integration circuit 60c.

Only one delay time determination circuit 70 is provided.

The delay circuits include a first delay circuit 80a, a second delay circuit 80b, and a third delay circuit 80c.

In the FPGA 30 for 3-parallel feedback control, the phase difference detection detects the phase differences between Sync1 and Sync2, between Sync2 and Sync3, and between Sync3 and Sync1, measures the respective phase difference times, performs correction factor integration, determines the delay time in the delay time determination circuit 70, and finally outputs PWM1, PWM2, and PWM3 from the respective delay circuits.

PWM1 is outputted to a first gate driver SiC1_101, PWM2 is outputted to a second gate driver SiC2_102, and PWM3 is outputted to a third gate driver SiC3_103.

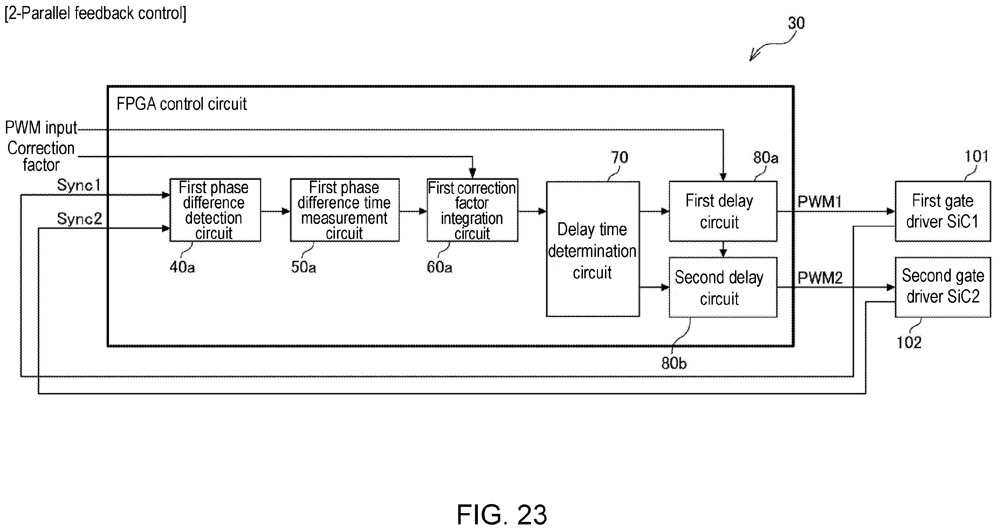

FIG. 23 is a diagram illustrating a circuit configuration of an FPGA for 2-parallel feedback control.

As the phase difference detection circuit, a first phase difference detection circuit 40a is provided.

As the phase difference time measurement circuit, a first phase difference time measurement circuit 50a is provided.

As the correction factor integration circuit, a first correction factor integration circuit 60a is provided.

Only one delay time determination circuit 70 is provided.

The delay circuits include a first delay circuit 80a and a second delay circuit 80b.

In the FPGA 30 for 2-parallel feedback control, the phase detection detects the phase difference between Sync1 and Sync2, measures the phase difference time, performs correction factor integration, determines the delay time in the delay time determination circuit 70, and finally outputs PWM from each delay circuit.

PWM1 is outputted to a first gate driver SiC1_101, and PWM2 is outputted to a second gate driver SiC2_102.

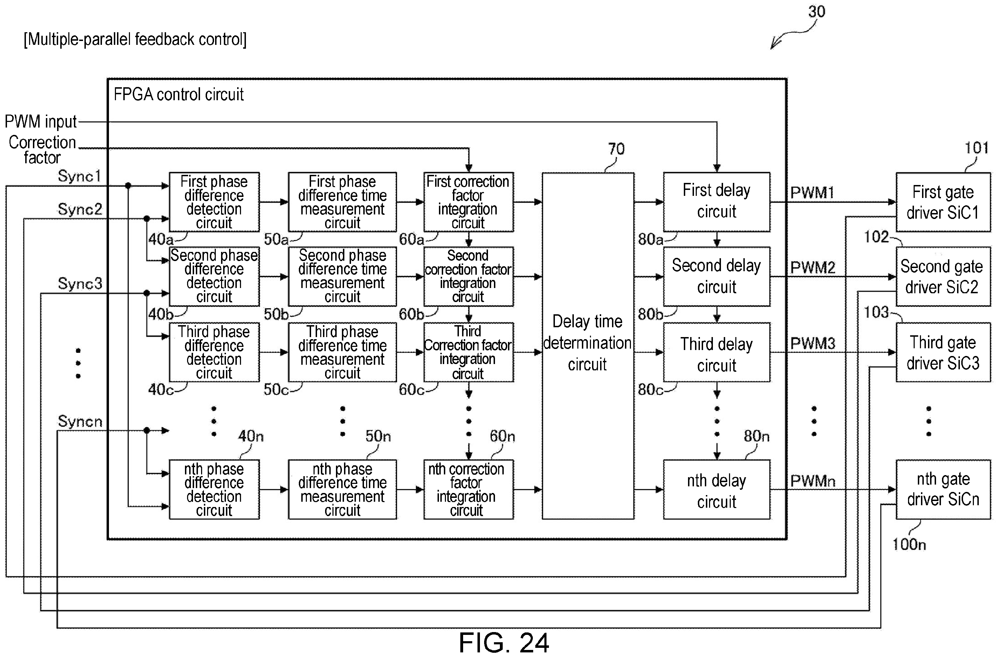

FIG. 24 is a diagram illustrating a circuit configuration of an FPGA for multi-parallel feedback control.

The phase difference detection circuits include a first phase difference detection circuit 40a, a second phase difference detection circuit 40b, a third phase difference detection circuit 40c, ..., and an nth phase difference detection circuit 40n.

The phase difference time measurement circuits include a first phase difference time measurement circuit 50a, a second phase difference time measurement circuit 50b, a third phase difference time measurement circuit 50c, ..., and an nth phase difference time measurement circuit 50n.

The correction factor integration circuits include a first correction factor integration circuit 60a, a second correction factor integration circuit 60b, a correction factor integration circuit 60c, ..., and a correction factor integration circuit 60n.

Only one delay time determination circuit 70 is provided.

The delay circuits include a first delay circuit 80a, a second delay circuit 80b, a third delay circuit 80c, ..., and an nth delay circuit 80n.

In the FPGA 30 for multi-parallel feedback control, the phase detection detects the phase differences between Sync1 and Sync2, Sync2 and Sync3, Sync(n-1) and Sync(n), and Sync(n) and Sync1, measures the respective phase difference times, performs correction factor integration, determines the delay time in the delay time determination circuit 70, and finally outputs PWM from each delay circuit.

PWM1 is outputted to a first gate driver SiC1_101, PWM2 is outputted to a second gate driver SiC2_102, PWM3 is outputted to a third gate driver SiC3_103, and PWMn is outputted to an nth gate driver SiCn_100n.

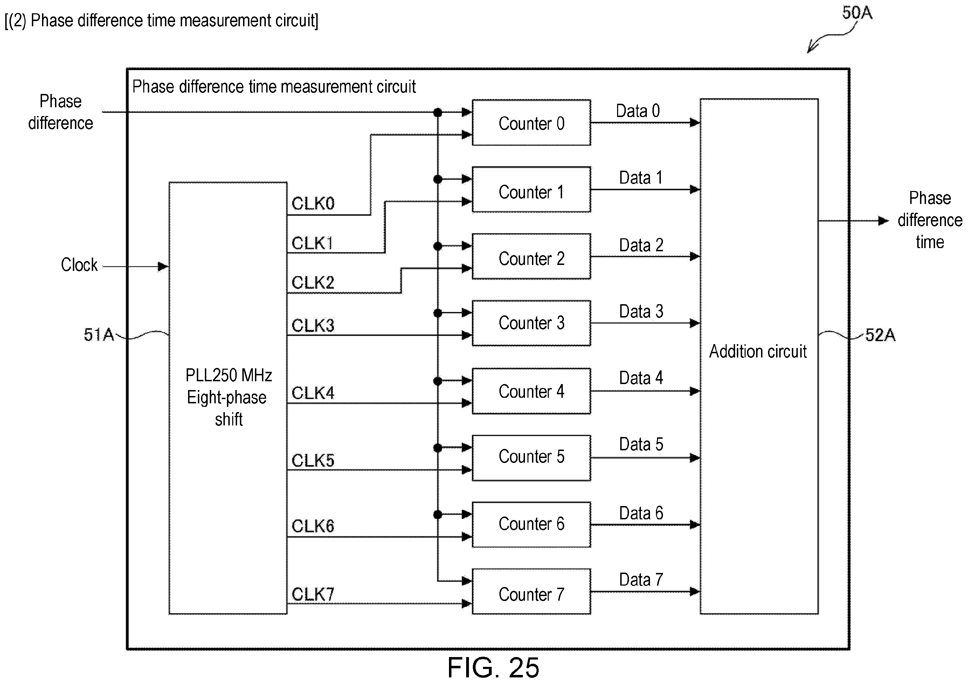

FIG. 25 is a diagram illustrating a modification example of the phase difference time measurement circuit 50.

As illustrated in FIG. 25, a phase difference time measurement circuit 50A is a circuit configured to receive a phase difference and a clock as inputs, and output a phase difference time. The phase difference (the phase detection pulse of FIG. 7) is inputted to the phase difference time measurement circuit 50A, CLK0 to CLK7 generated by a PLL 51A control counters 0 to 7, and data 0 to data 7 are added by an addition circuit 52A to measure the phase difference time. In addition, the phase difference time measurement circuit 50A uses a 250 MHz, eight-phase shift PLL 51A to measure (resolve) the phase difference pulse at a time resolution of 0.5 ns. Accordingly, the resolution of the phase difference time measurement circuit 50A can be set to 0.5 ns, which is twice that of FIG. 8.

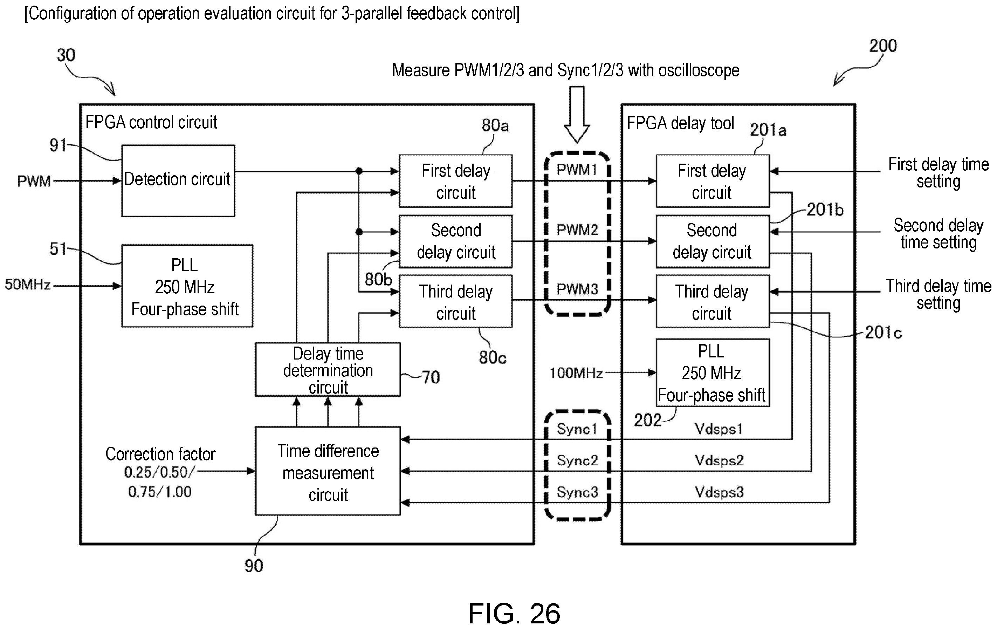

FIG. 26 is a diagram illustrating a configuration of an operation evaluation circuit for 3-parallel feedback control.

The FPGA 30 illustrated on the left side of the diagram has the same configuration as that of FIG. 4.

An FPGA delay tool 200 illustrated on the right side of the diagram is a tool for evaluating the FPGA 30. The FPGA delay tool 200 includes a first delay circuit 201a, a second delay circuit 201b, a third delay circuit 201c, and a PLL 202.

The first delay circuit 201a is a circuit configured to receive PWM1 as an input, and output Vdsps1 delayed by a first delay time that is freely settable by a switch or the like.

The second delay circuit 201b is a circuit configured to receive PWM2 as an input, and output Vdsps2 delayed by a second delay time that is freely settable by a switch or the like.

The third delay circuit 201c is a circuit configured to receive PWM3 as an input, and output Vdsps3 delayed by a third delay time that is freely settable by a switch or the like.

The first delay circuit 201a, the second delay circuit 201b, and the third delay circuit 201c are each capable of having their delay time set individually. The setting range is 0 to 63 ns/1 ns unit.

The PLL 202 receives a 100 MHz clock as an input and operates with a four-phase shift at 250 MHz.

Vdsps1 to Vdsps3 are converted to Sync1 to Sync3 by the FPGA delay tool 200 and inputted to the FPGA 30. PWM1, PWM2, and PWM3 and Sync1, Sync2, and Sync3 are measured with an oscilloscope.

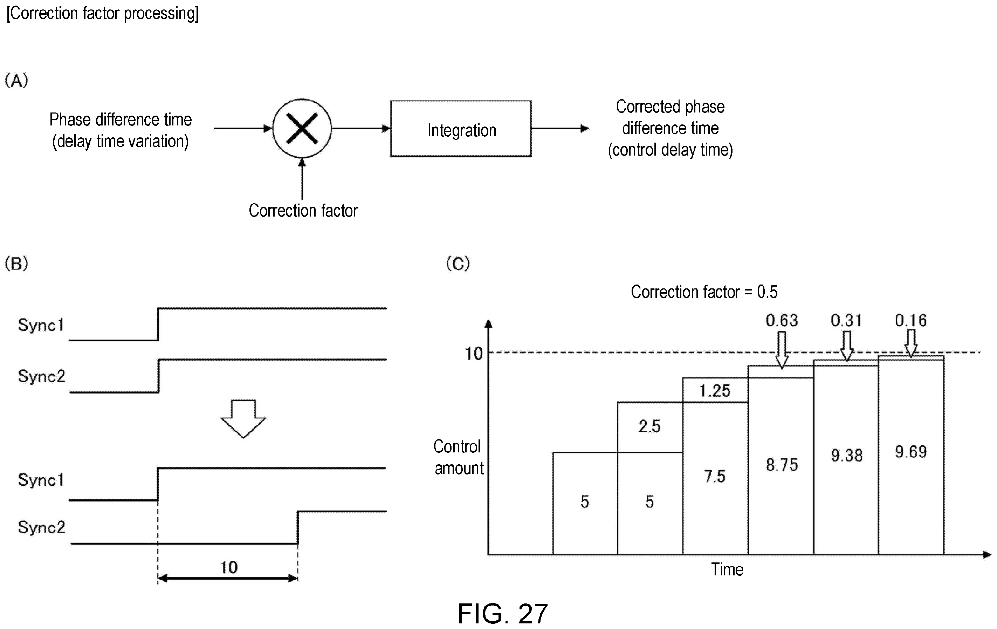

FIG. 27 is a diagram showing an overview of the correction factor processing.

As shown in FIG. 27(A), the phase difference time (delay time variation) can be converted into a corrected phase difference time (control delay time) by integrating the correction factor.

For example, as shown in FIG. 27(B), in the case where Sync1 and Sync2 are at the same timing and Sync2 is delayed by 10 ns from Sync1, the phase difference time is 10 ns. In the case where the correction factor is 1.0, subsequent calculations proceed based on this 10 ns; however, in the case where the correction factor is 0.5, subsequent calculations proceed based on 5 ns, which is obtained by multiplying this 10 ns by the correction factor.

For this reason, as shown in FIG. 27(C), assuming that the phase difference time decreases by half over time from 10 ns, in the case where the correction factor is 0.5, the corrected phase difference time can be gradually reduced as follows: "5 ns (= 10 ns × 0.5)" → "2.5 ns (= 5 ns × 0.5)" → "1.25 ns (= 2.5 ns × 0.5)" → and so on, with the control amount (corrected phase difference time) reduced little by little.

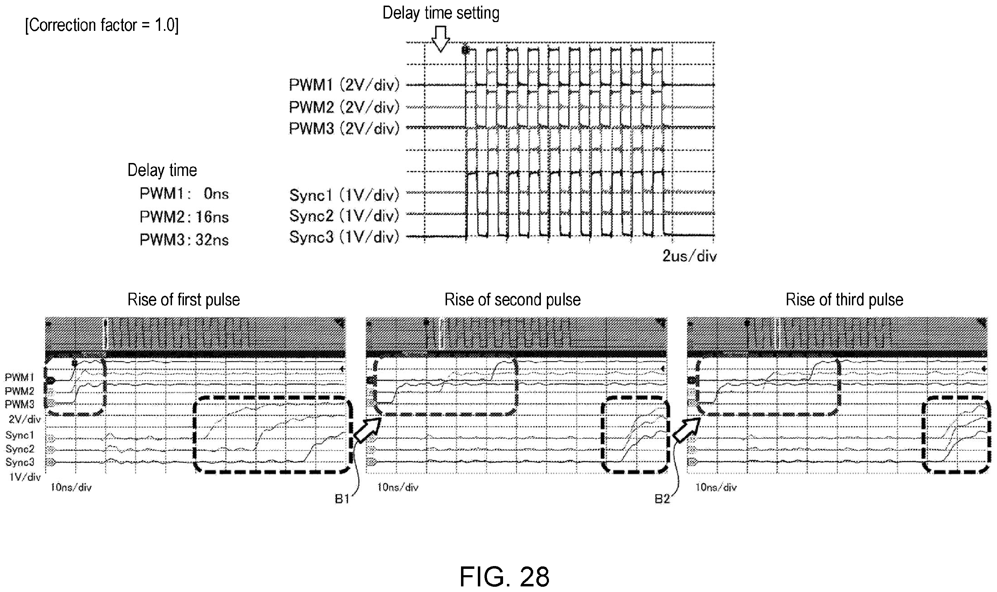

FIG. 28 is a diagram showing the measurement results in the case where the correction factor is 1.0.

The delay times in the FPGA delay tool 200 are set as follows: PWM1: 0 ns, PWM2: 16 ns, and PWM3: 32 ns. The delay time is set only once at the beginning of multiple pulses.

In such a case, at the rise of the first pulse, Sync2 is greatly behind as viewed from Sync 1, and Sync3 is greatly behind as viewed from Sync2. However, based on this delay, delay control of PWM1 to PWM3 is performed. Specifically, PWM1 and PWM2 are delayed to align PWM1 and PWM2 with PWM3 corresponding to Sync3, which is most behind (see an arrow B1).

At the rise of the second pulse, Sync1 to Sync3 are mostly aligned. However, since there is a slight deviation, delay control of PWM1 to PWM3 is performed to adjust the slight deviation (see an arrow B2).

At the rise of the third pulse, Sync1 to Sync3 are substantially aligned. However, since there is a slight deviation, delay control of PWM1 to PWM3 is performed to adjust the slight deviation.

In this manner, with a correction factor of 1.0, the deviation among Sync1 to Sync3 is substantially eliminated by the time of the rise of the third pulse.

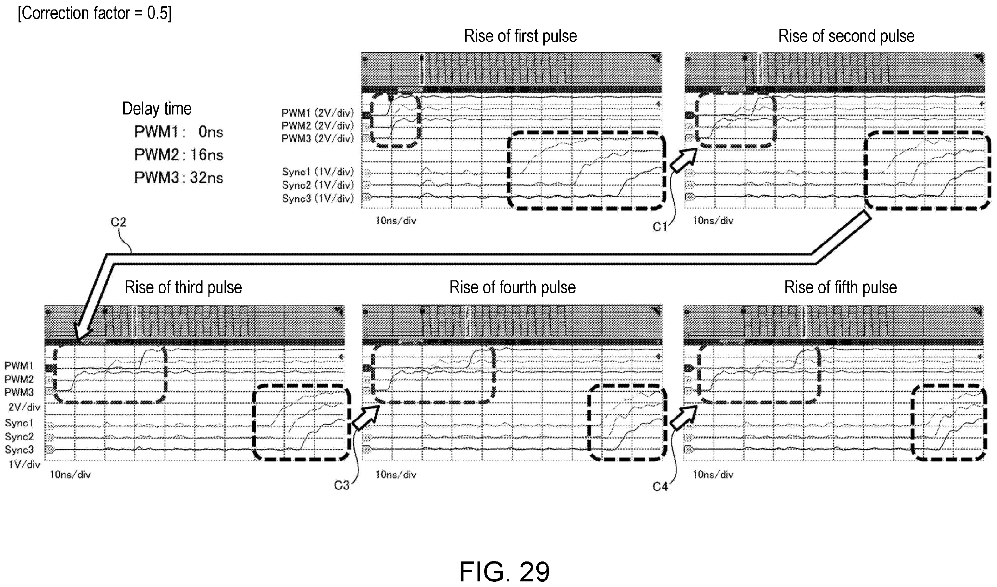

FIG. 29 is a diagram showing the measurement results in the case where the correction factor is 0.5. The measurement conditions other than the correction factor are the same as those in FIG. 28.

In the case where the correction factor is 0.5, at the rise of the first pulse, Sync2 is greatly behind as viewed from Sync1, and Sync3 is greatly behind as viewed from Sync2. Based on this delay, delay control of PWM1 to PWM3 is performed. Specifically, PWM1 and PWM2 are delayed to align PWM1 and PWM2 with PWM3 corresponding to Sync3, which is most behind (see an arrow C1).

At the rise of the second pulse, Sync2 is behind as viewed from Sync1, and Sync3 is behind as viewed from Sync2. Based on this delay, delay control of PWM1 to PWM3 is performed. Specifically, PWM1 and PWM2 are delayed to align PWM1 and PWM2 with PWM3 corresponding to Sync3, which is most behind (see an arrow C2).

At the rise of the third pulse, Sync2 is slightly behind as viewed from Sync1, and Sync3 is slightly behind as viewed from Sync2. Based on this delay, delay control of PWM1 to PWM3 is performed. Specifically, PWM1 and PWM2 are delayed to align PWM1 and PWM2 with PWM3 corresponding to Sync3, which is most behind (see an arrow C3).

At the rise of the fourth pulse, Sync2 is slightly behind as viewed from Sync1, and Sync3 is slightly behind as viewed from Sync2. Based on this delay, delay control of PWM1 to PWM3 is performed. Specifically, PWM1 and PWM2 are delayed to align PWM1 and PWM2 with PWM3 corresponding to Sync3, which is most behind (see an arrow C4).

At the rise of the fifth pulse, Sync1 to Sync3 are substantially aligned. However, since there is a slight deviation, delay control of PWM1 to PWM3 is performed to adjust the deviation.

In this manner, with the correction factor of 0.5, the deviation among Sync1 to Sync3 is gradually eliminated by the time of the rise of the fifth pulse.

In this manner, upon reducing the value of the correction factor, it takes more time for Sync to align, but Sync can be aligned gradually and slowly.

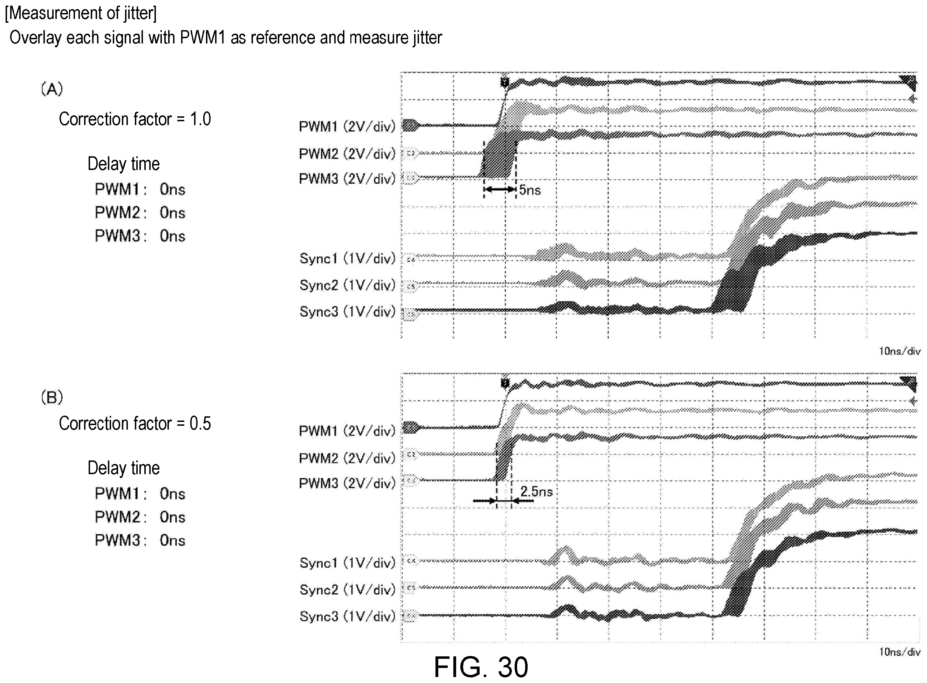

FIG. 30 is a diagram illustrating the measurement results of a jitter.

Herein, a jitter is measured by overlaying each signal with PWM1 as a reference.

As illustrated in FIG. 30(A), in the case of a correction factor of 1.0, a deviation of 5 ns occurs as a jitter. On the other hand, as illustrated in FIG. 30(B), in the case of a correction factor of 0.5, a deviation of 2.5 ns occurs as a jitter.

In this manner, upon reducing the correction factor, the jitter width is reduced. This indicates that variations occur within the circuits, and if control is directly applied thereto, control would be applied in an incorrect direction, and variations would be amplified. Such an increase in jitter width can be prevented by setting the correction factor. For this reason, even in the case of a large change (in the case where the phase difference time is large), the jitter width can be reduced by making changes only little by little (by reducing the phase difference time little by little).

The correction factor may be a predetermined fixed value, or may be a variable value such that the correction factor is increased at the start of control and decreased as the control stabilizes. In addition, in some cases, the correction factor may be decreased at the start of control and increased as the control stabilizes.

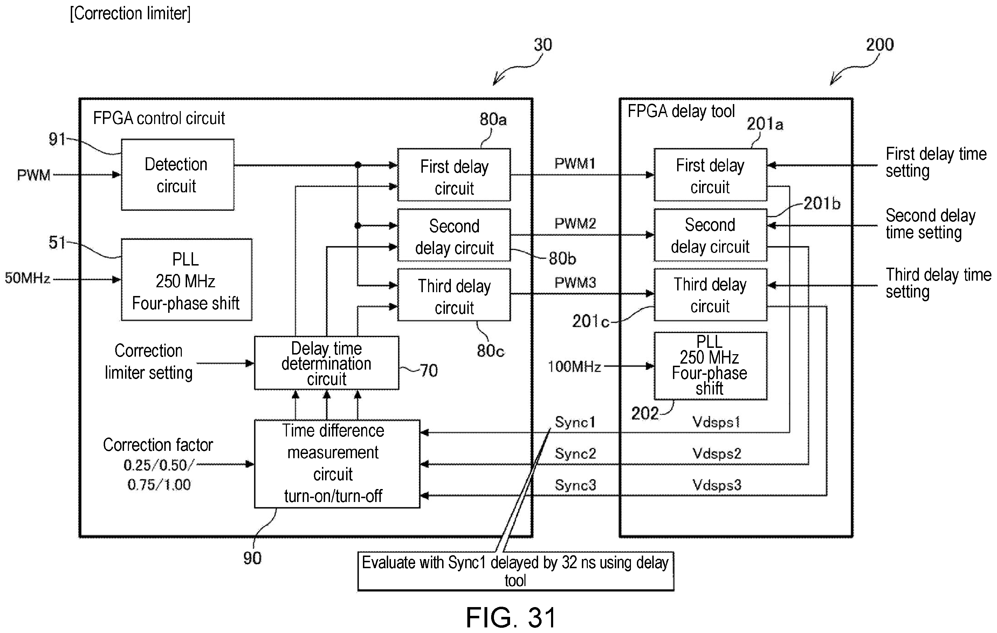

FIG. 31 is a diagram illustrating the configuration of a correction limiter.

The circuit configuration is basically the same as that of FIG. 26; however, the delay time determination circuit 70 has a correction limiter setting function.

The correction limiter is a limiter configured to determine a maximum value of the delay time. The correction limiter may be set to a fixed value (for example, 15 ns).

Herein, the FPGA delay tool 200 evaluates by delaying Sync1 by 32 ns.

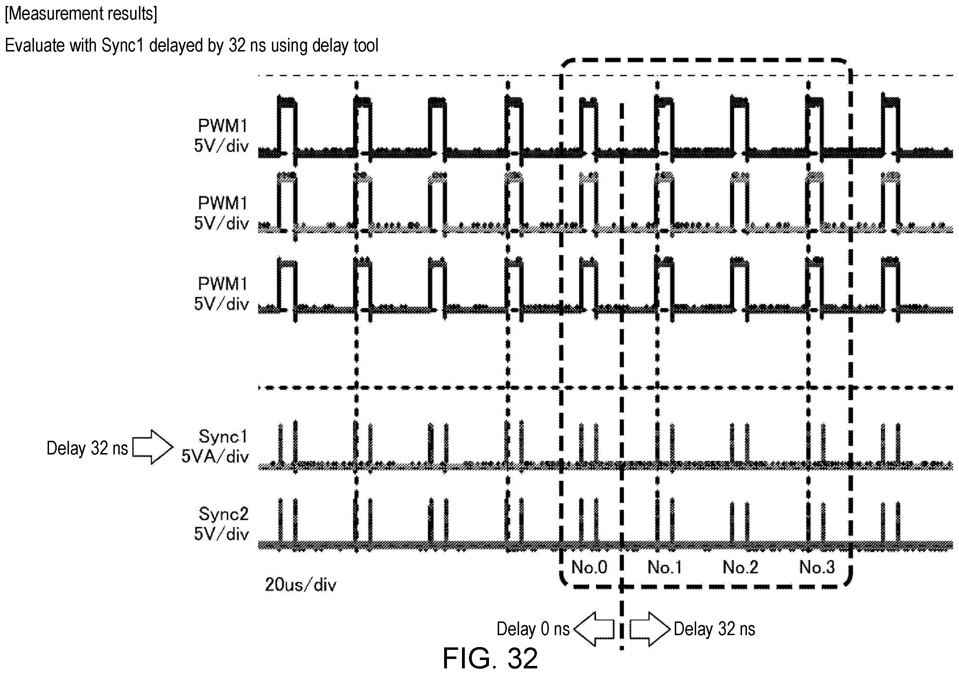

FIG. 32 is a diagram illustrating the measurement results of the correction limiter.

In FIG. 32, only Sync1 and Sync2 are illustrated for PWM1, PWM2, and PWM3. At the timing of No. 0, Sync1 has a delay of 0, and at the timing of No. 1, the FPGA delay tool 200 is used to forcibly delay Sync1 by 32 ns.

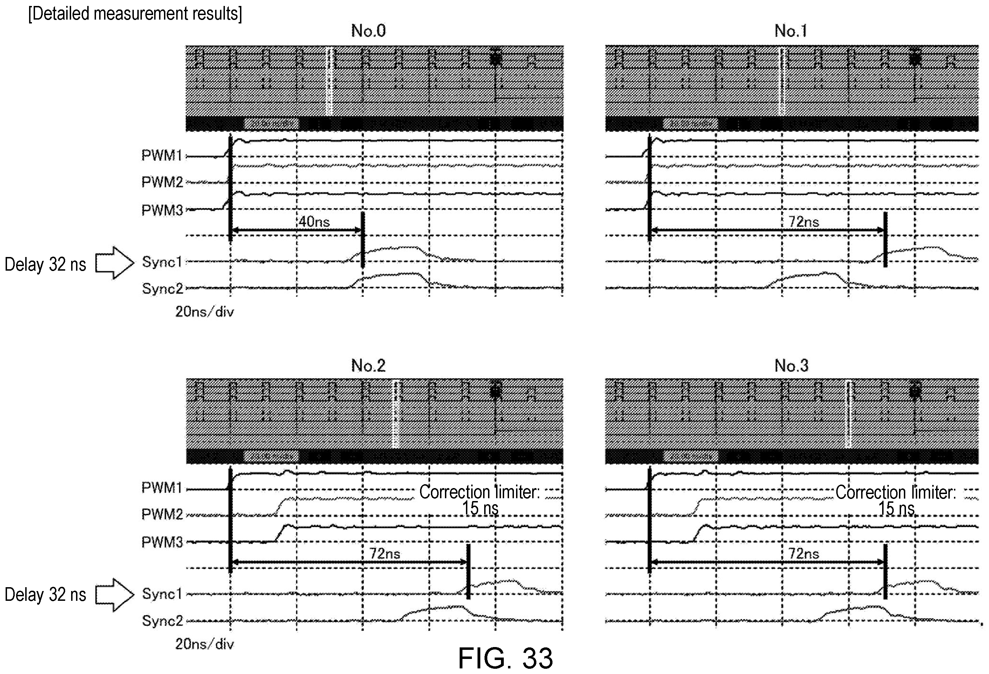

FIG. 33 is a diagram illustrating the details of the measurement results of the correction limiter.

At the timing of No. 0, Sync1 has a delay of 0. In such a case, PWM1, PWM2, and PWM3 are aligned. Sync1 is behind by 40 ns with respect to PWM1 due to internal processing and the like.

At the timing of No. 1, Sync1 is forcibly delayed by 32 ns. Specifically, the delay becomes 40 ns + 32 ns, and Sync1 is behind by 72 ns with respect to PWM1. At this point, PWM1, PWM2, and PWM3 are aligned.

At the timing of No. 2, the correction limiter is in a state where control is applied. Under normal circumstances, PWM2 and PWM3 are to be delayed substantially (by 16 ns or more) in order to align Sync2 with Sync1 which is behind; however, because the correction limiter is present, PWM2 and PWM3 are delayed by a maximum of only 15 ns.

At the timing of No. 3 as well, the correction limiter is in a state where control is applied. For this reason, PWM2 and PWM3 are delayed by a maximum of only 15 ns.

By using such a function of the correction limiter, abrupt changes in PWM1, PWM2, and PWM3 can be avoided.

As described above, according to the present embodiment, the following effects are achieved.
(1) Because the operating frequency of the FPGA 30 is at most several hundred MHz, the resolution of time measurement is several nsec. For this reason, time measurement at a resolution beyond the operating frequency (less than 4 ns) is difficult. Accordingly, in the present embodiment, with a circuit configuration using a PLL, a circuit capable of improving the resolution (a circuit capable of measuring time at a resolution of 1 nsec) can be provided.
(2) Because the operating frequency of the FPGA 30 is at most several hundred MHz, the time unit of signal delay is several nsec. For this reason, ensuring a time unit of signal delay beyond the operating frequency (less than 4 ns) is difficult. Accordingly, in the present embodiment, with a circuit configuration using a PLL, a circuit capable of improving the time unit of signal delay (a circuit capable of delaying a signal (PWM) in units of 1 nsec) can be provided.
(3) According to the present embodiment, because PWM1, PWM2, and PWM3 (output signals) are delayed based on Sync1, Sync2, and Sync3 (input signals), the variation in phase of the gate driver SiCs can be suppressed, and the gate driver SiCs (multiple external devices) can be driven in correct synchronization.
(4) According to the present embodiment, because a correction factor is used, the gate driver SiCs (multiple external devices) can be gradually brought into synchronization.
(5) According to the present embodiment, because a phase-locked loop (PLL) is used, time measurement and signal delay can be performed at a resolution (a resolution of 1 ns or less) beyond the maximum operating frequency (4 ns) of the delay control circuit.

### [Modification Example]

The present invention is not limited to the embodiments described above, and may be implemented in various modification examples.
(1) The output signals have been described using PWM1, PWM2, and PWM3 as examples, but other signals may also be used. The input signals have been described using Sync1, Sync2, and Sync3 as examples, but other signals may also be used.
(2) It is also possible that the correction factor and the correction limiter are not adopted.
(3) It is also possible that the phase difference time measurement unit does not use a phase-locked loop.
(4) SiC has been described using a four-terminal SiC as an example, but a three-terminal SiC may also be used. In the case where a three-terminal configuration is adopted with the terminal of the driver source T3 omitted, a shunt resistor may be disposed adjacent to the coils 16 or the motor, and a waveform (input signal) serving as a substitute for Sync may be outputted to the FPGA from the waveform of the shunt resistor.
(5) Although some descriptions have been omitted for the rise and fall, PWM1, PWM2, and PWM3, and Sync1, Sync2, and Sync3, the control content of one processing may be modified to content suitable for the control content of another processing and applied.
(6) In addition, the structures and circuit configurations illustrated and described in the embodiments are merely preferred examples, and various elements may be added to the basic structure, some configurations may be replaced, or some configurations may be deleted.

### Reference Signs List

- 10: drive circuit
- 11: power supply
- 12: control board
- 13, 14, 15: power switching device
- 16: coil
- 20a: first gate driver
- 20b: second gate driver
- 20c: third gate driver
- 30: FPGA
- 40: phase difference detection circuit
- 50: phase difference time measurement circuit
- 51: PLL
- 60: correction factor integration circuit
- 70: delay time determination circuit
- 80: delay circuit
- 90: time difference measurement circuit
- 91: detection circuit
- 100: gate driver SiC

## Claims

1. A delay control circuit configured to output an output signal to each of a plurality of external devices connected in parallel, receive an input signal based on the output signal from each of the external devices, and delay the output signal based on the input signal, the delay control circuit comprising:
a phase difference detection unit configured to detect a phase difference of the input signal inputted from each of the external devices;
a phase difference time measurement unit configured to measure a phase difference time of the phase difference detected by the phase difference detection unit;
an integration unit configured to calculate an integrated value by performing addition and subtraction of a previous phase difference time with respect to a current phase difference time measured by the phase difference time measurement unit;
a delay time determination unit configured to determine a delay time of the output signal based on the integrated value calculated by the integration unit; and
a delay unit configured to delay the output signal based on the delay time determined by the delay time determination unit.

2. The delay control circuit according to claim 1, wherein
the integration unit multiplies the current phase difference time measured by the phase difference time measurement unit by a predetermined correction factor.

3. The delay control circuit according to claim 1, wherein
a phase-locked loop is used as the phase difference time measurement unit.
